# EUROPEAN PATENT SPECIFICATION

(11) **EP 4 505 286 B1**
(45) Date of publication and mention of the grant of the patent: **11.03.2026**
(21) Application number: 22721040.8
(22) Date of filing: 06.04.2022
(51) Int. Cl.: G06F 7/544

(54) **MULTI-BIT ANALOG MULTIPLY-ACCUMULATE OPERATIONS WITH MEMORY CROSSBAR ARRAYS**
MULTIBIT-ANALOGE MULTIPLIZIER-AKKUMULIER-OPERATIONEN MIT SPEICHER-CROSSBAR-ARRAYS
OPÉRATIONS DE MULTIPLICATION-ACCUMULATION ANALOGIQUE À BITS MULTIPLES AVEC RÉSEAUX CROSSBAR DE MÉMOIRE

(43) Date of publication of application: 12.02.2025
(73) Proprietor: Axelera AI BV, 5656 AE Eindhoven (NL)
(72) Inventor: KHADDAM-ALJAMEH, Riduan, 5656 AE Eindhoven (NL); ELEFTHERIOU, Evangelos, 5656 AE Eindhoven (NL); COSEMANS, Stefan, 5656 AE Eindhoven (NL)
(74) Representative: E. Blum & Co. AG
(86) International application number: PCT/EP2022/059113
(87) International publication number: WO 2023/193899

(56) References cited:
- US-B1- 10 777 253
- KHADDAM-ALJAMEH RIDUAN ET AL: "An SRAM-Based Multibit In-Memory Matrix-Vector Multiplier With a Precision That Scales Linearly in Area, Time, and Power", IEEE TRANSACTIONS ON VERY LARGE SCALE INTEGRATION (VLSI) SYSTEMS, IEEE SERVICE CENTER, PISCATAWAY, NJ, USA, vol. 29, no. 2, 9 December 2020 (2020-12-09), pages 372 - 385, XP011835114, ISSN: 1063-8210, [retrieved on 20210126], DOI: 10.1109/TVLSI.2020.3037871

## Description

### BACKGROUND

The invention relates in general to the field of in- and near-memory processing techniques (i.e., methods, apparatuses, and systems) and related acceleration techniques. In particular, it relates to a method of processing data using memory devices having a crossbar array structure, augmented with compute units configured as interleaved switched-capacitor analogue multipliers and adders, where the compute units are operated according to a 3-phase clocking scheme, which is set to perform partial multiplications and additions in the analogue domain according to a certain bit partition.

Matrix-vector multiplications (MVMs) are frequently needed in several applications, such as technical computing applications and, in particular, cognitive tasks. Examples of such cognitive tasks are the training of, and inferences performed with, cognitive models such as neural networks for computer vision and natural language processing, and other machine learning models such as those used for weather forecasting and financial predictions.

MVM operations pose multiple challenges, because of their recurrence, universality, matrix size, and memory requirements. On the one hand, there is a need to accelerate these operations, notably in high-performance computing applications. On the other hand, there is a need to achieve an energy-efficient way of performing them.

Traditional computer architectures are based on the von Neumann computing concept, where processing capability and data storage are split into separate physical units. Such architectures suffer from congestion and high-power consumption, as data must be continuously transferred from the memory units to the control and arithmetic units through physically constrained and costly interfaces.

One possibility to accelerate MVMs is to use dedicated hardware acceleration devices, such as dedicated circuits having a crossbar array configuration. This type of circuit includes input lines and output lines, which are interconnected at cross-points defining cells. The cells contain respective memory devices (or sets of memory devices), which are designed to store respective matrix coefficients. Vectors are encoded as signals applied to the input lines of the crossbar array to perform multiply-accumulate (MAC) operations. There are several possible implementations. For example, the coefficients of the matrix ("weights") can be stored in columns of cells. Next to every column of cells is a column of arithmetic units that can multiply the weights with input vector values (creating partial products) and finally accumulate all partial products to produce the outcome of a full dot-product. Such an architecture can simply and efficiently map a matrix-vector multiplication. The weights can be updated by reprogramming the memory elements, as needed to perform matrix-vector multiplications. Such an approach breaks the "memory wall" as it fuses the arithmetic- and memory unit into a single in-memory-computing (IMC) unit, whereby processing is done much more efficiently in or near the memory (i.e., the crossbar array).

The following paper forms part of the background art:
- R. Khaddam-Aljameh, P. -A. Francese, L. Benini and E. Eleftheriou, "An SRAM-Based Multibit In-Memory Matrix-Vector Multiplier With a Precision That Scales Linearly in Area, Time, and Power," in IEEE Transactions on Very Large Scale Integration (VLSI) Systems, vol. 29, no. 2, pp. 372-385, Feb. 2021, doi: 10.1109/TVLSI.2020.3037871, hereafter referred to as "PA1";
- US Patent Document US10777253 (B1), "Memory array for processing an N-bit word", R. Khaddam-Aljameh, M. Le Gallo-Bourdeau, A. Sebastian, E. Eleftheriou, and A. Francese, hereafter "PA2";
- Digest of Technical Papers (pp. 236-238). [9365788] (Digest of Technical Papers - IEEE International Solid-State Circuits Conference; Vol. 64), Institute of Electrical and Electronics Engineers Inc., https://doi.org/10.1109/ISSCC42613.2021.9365788, hereafter "PA3";
- Jia, H., Ozatay, M., Tang, Y., Valavi, H., Pathak, R., Lee, J., & Verma, N. (2021), "A Programmable Neural-Network Inference Accelerator Based on Scalable In-Memory Computing,", in 2021 IEEE International Solid-State Circuits Conference, ISSCC 2021;
- F. -J. Wang, G. C. Temes and S. Law, "A quasi-passive CMOS pipeline D/A converter," in IEEE Journal of Solid-State Circuits. vol. 24, no. 6, pp. 1752-1755, Dec. 1989, doi: 10.1109/4.45017; and
- P. F. Ferguson, X. Haurie and G. C. Temes, "A highly linear low-power 10 bit DAC for GSM," Proceedings of the IEEE 2000 Custom Integrated Circuits Conference (Cat. No.00CH37044), 2000, pp. 261-264, doi: 10.1109/CICC.2000.852662.

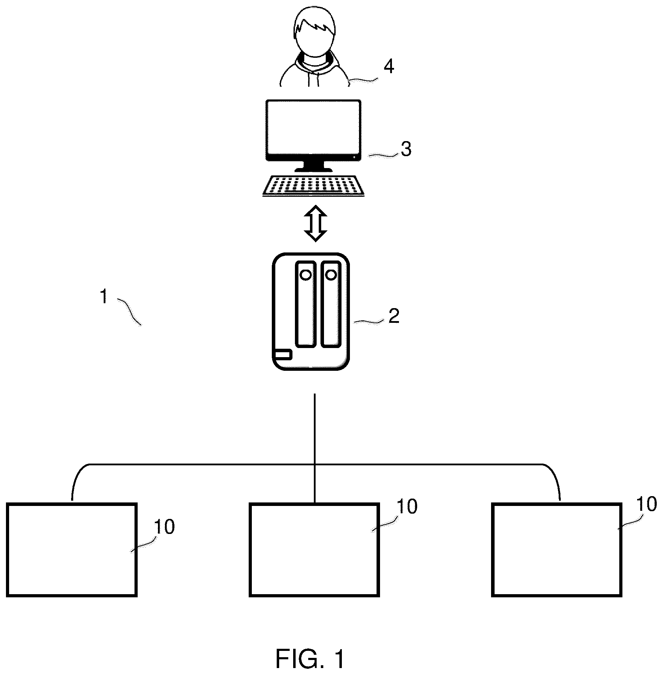

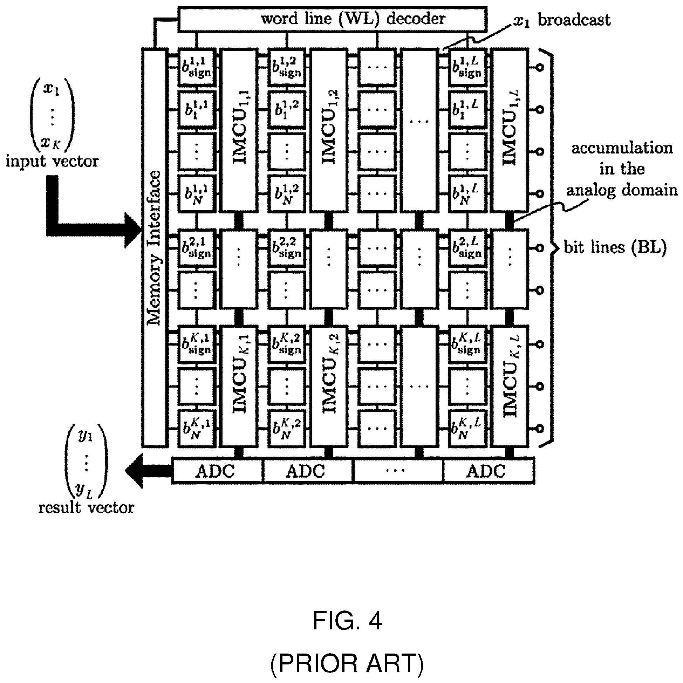

The document PA1 discloses techniques of operating a memory device having a crossbar array structure, where the crossbar array structure includes cells interconnecting rows and columns. The cells include memory elements (namely static random-access memory elements, or SRAM elements) storing respective N-bit weights. The memory elements are connected to respective in-memory compute units, or IMCUs. The IMCUs are collocated with the memory elements in the array, as depicted in Fig. 1(b) of PA1, which corresponds to FIG. 4 in the drawings accompanying the present document. The IMCUs are configured as interleaved switched-capacitor analogue multipliers and adders, which are designed to efficiently perform the matrix-vector multiplications. The crossbar array structure is operated by applying input signals encoding respective *M*-bit input words to respective rows. The IMCUs are operated according to a 3-phase clocking scheme, to obtain multiply-accumulate (MAC) results for each column.

Each IMCU first converts an *N*-bit weight into a proportional voltage using a pipeline of digital-to-analogue converter (DAC) built from *N +* 1 equally sized stages. A switched-capacitor stage then multiplies these voltages with the M-bit digital input activation. Finally, the output voltages that correspond to the different multiplication results are accumulated along each column by means of charge sharing.

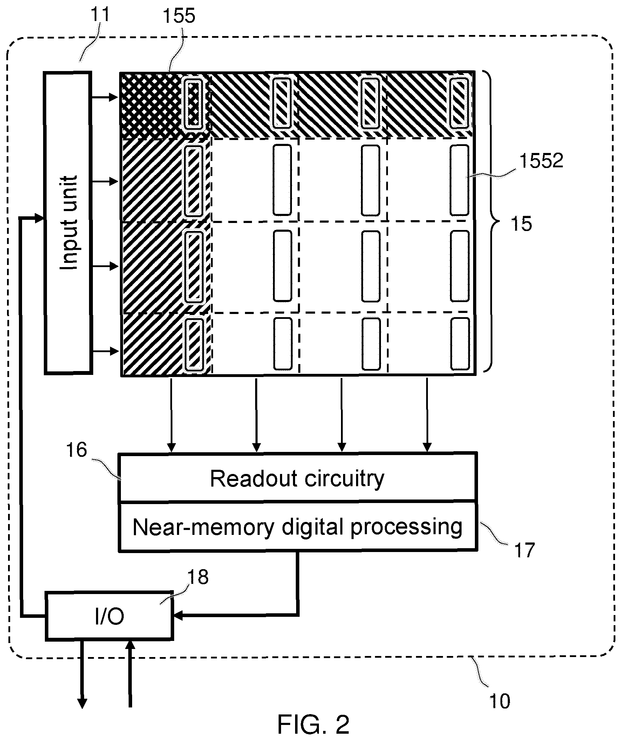

In more detail, the interleaved switched-capacitor circuit shown in Fig. 2 of PA1 causes each pipelined DAC to generate a voltage, which is proportional to the stored weight bits representing the unsigned weight. The sign of the precharge voltage is selected based on the sign of both the input and weight. An analogue multiplier performs a multibit multiplication as a series of binary multiplication steps, by suitably controlling switches. Based on each input bit, either zero or a weight with a proportional amount of charge is added to an output capacitor. An analogue accumulator performs the summation of all multiplication results of the IMCUs along each column by means of charge sharing.

The 3-phase clocking scheme used to operate the IMCUs is illustrated in Fig. 4 of PA1. The 3-phase clocking scheme causes the IMCUs to perform *N* × M multiplications. A sequence of *M* groups of clock cycles are associated with respective sequence of *M* bits, corresponding to the input words. A phase signal is applied during each clock cycle of the *M* groups. The clocking scheme causes an additional input bit to be processed every three clock cycles, until all bits of the input magnitude have been multiplied and accumulated.

Thanks to the collocated architecture, the IMCU circuits, and the 3-phase clocking scheme proposed in PA1, the required circuit area, computation time, and power consumption, scale linearly with the bit resolution of both the inputs and the weights.

The document PA2 discloses similar clocking schemes, interleaved switched-capacitor circuits, and crossbar architectures. So, IMCUs configured as interleaved switched-capacitor analogue multipliers and adders are known *per se,* as well as the 3-phase clocking schemes to operate them.

The document PA3 presents a scalable neural-network inference accelerator based on an array of programmable cores employing mixed-signal in-memory computing, digital near-memory computing, and localized buffering/control. The compute units are operated based on a multi bit-slicing approach, resulting in *N* × *M* partial multiplications at each cell. Bit slicing is applied to the input vector elements, which are mapped onto voltage vector inputs to the crossbar array, one at a time. To perform an in-place matrix-vector multiplication, a vector slice is multiplied with a matrix slice, with O(1) time complexity, and the partial products of these operations are combined outside of the crossbar array device through a shift-and-add reduction network.

More generally, various IMC approaches have been proposed. In general, the MVMs can be performed in the digital or analogue domain. Implementations in the analogue domain can show better performance in terms of area and energy-efficiency when compared to fully digital IMCs. This, however, comes at the cost of a limited computational precision.

Physical implementations of analogue IMC circuitry in CMOS (e.g., using SRAM or equivalent memory technology) often rely on switched capacitors circuits where the multi-bit MVMs are executed in a single time step, as in PA1 or PA2. Alternatively, such operations can be performed as a combination of binary operations (i.e., "bit-slicing") in the analogue domain, followed by analogue-to-digital conversion (using analogue-to-digital converters, or ADCs) and then shift-and-add operations on the partial results, as in PA3. Other approaches rely on SRAM cells, which exploit binary inputs and binary weights. Alternatively, one can also use phase-change memory (PCM) technology for multibit operations, albeit with limited precision.

Each analogue computation mode, i.e., single-bit or multibit analogue computation mode, has its pros and cons. Performing multi-bit operations in a single step in the analogue domain may limit the analogue signal range, incur more noise, and complicate the ADC and DAC design, while a fully bit-sliced mode requires more ADC conversion steps, which, in turn, incurs higher latency and consumes more energy.

After a perusal investigation of the available IMC approaches and related techniques, the present inventors came up with new designs and operation methods of memory devices based on crossbar array structures, which make it possible to reduce analogue compute signal-to-noise ratio requirements, while making full use of pipelining and thus maximizing the system throughput.

### SUMMARY

According to a first aspect, the present invention is embodied as a method of processing data. The method relies on a memory device having a crossbar array structure. The latter includes *K* × *L* cells, which interconnect *K* rows and *L* columns. The cells include respective memory systems, which store respective *N*-bit weights. The memory systems are connected to respective compute units, which are configured as interleaved switched-capacitor analogue multipliers and adders. According to the proposed method, input signals encoding respective *M*-bit input words are synchronously applied to respective ones of the *K* rows. The compute units are operated according to a 3-phase clocking scheme, with a view to obtaining MAC results for each of the *L* columns, where *K* ≥ 2, *L* ≥ 2, *N* ≥ 2, and *M* ≥ 2.

Remarkably, the 3-phase clocking scheme is here set to perform *n* × *m* partial multiplications, in the analogue domain (i.e., as analogue operations), according to a specific bit partition, so as to obtain *n* × *m* partial output signals in output of each of the compute units. This partition decomposes each of the *N*-bit weights into *n* groups of bits and each of the M-bit input words into *m* groups of bits. Each of the *n* groups and the *m* groups includes at least one bit. However, at least one of the *n* groups and/or the *m* groups includes at least two bits, whereby *N + M > n + m* ≥ 3. Moreover, the MAC results are obtained by summing the partial output signals obtained by the compute units for each of the *L* columns. The summed output signals are converted into digital signals encoding partial values. The partial values are shifted according to corresponding bit positions, which are set in accordance with the bit partition, and the shifted values are finally added, so as to recompose the desired output vector components.

The present approach relies on a specific bit partition, which can be regarded as resulting in a granular bit slicing. This proposed solution reduces the analogue compute signal-to-noise ratio requirements. At the same time, the proposed approach can maintain the pipeline behaviour of the system, yet without impacting the throughput.

In embodiments, the granularity of the bit partition of the *N*-bit weights and the *M*-bit input words is asymmetric. That is, an average number of bits of the *n* groups differs from an average number of bits of the *m* groups. Even if the groups do not need to have a same number of bits, simpler implementations are nevertheless achieved by imposing each of the *n* groups to have a same number v of bits and, similarly, each of the *m* groups to have a same number *µ* of bits, though v may differs from *µ*. For example, the bit partition may be designed so as to decompose each of the *N*-bit weights into *n* groups of v bits, such that *N* = *n* × v, where *v* ≥ 2, and each of the *M*-bit input words into a single group of *M* bits, whereby *m* = 1. A preferred variant is to decompose each of the *M*-bit input words into *m* groups of *µ* bits, such that *M = m* × *µ,* where *µ* ≥ 2, and each of the *N*-bit weights into a single group of *N* bits, whereby *n =* 1. This allows an easier operation of the compute unit.

In embodiments, the compute units are collocated with the respective memory systems to which they are connected and form part of the respective cells. Thus, the *n* × *m* partial multiplications are efficiently performed as in-memory operations in the memory device in that case. In variants, the compute units are arranged in a near-memory (analogue) processing unit, as discussed below.

The MAC results are typically obtained via a readout circuitry, which includes analogue-to-digital converters (ADCs) and digital shift-and-adder circuits. The ADCs are connected to respective columns of the compute units for converting the partial output signals as summed for each of the *L* columns into the digital signals. Note, the compute units form columns, whether collocated with the memory systems in the cells, or not. The digital shift-and-adder circuits are connected in output of respective ones of the ADCs for shifting the partial values and adding the shifted values. The readout circuitry is preferably co-integrated with the crossbar array structure in the memory device.

In preferred embodiments, the compute units are operated thanks to first control signals, which include 3-phase signals for implementing the 3-phase clocking scheme. The MAC results are obtained by applying second control signals, which are in phase with the 3-phase signals, so as to enable a synchronous operation of the compute units and the readout circuitry. The second control signals include first activation signals and second activation signals. The first activation signals activate the ADCs for converting the partial output signals. The second activation signals activate the digital shift-and-adder circuits for shifting the partial values and adding the shifted values.

Preferably, the 3-phase clocking scheme spans a sequence of clock cycles, wherein the sequence decomposes into *M* sets of clock cycles associated with respective *M* bits of the *M-*bit input words. The 3-phase signals are repeatedly applied, *M* times, during the *M* sets of clock cycles. Each of the *M* sets includes three clock cycles, during which the 3-phase signals are successively applied, such that only one phase signal of the 3-phase signals is applied during a single one of the three clock cycles.

In embodiments, each memory system of the memory systems of each cell of the *K* × *L* cells consists of *N* serially-connected memory elements, each storing a respective bit of one of the *N* bits of the *N*-bit weights that is stored in said each cell. A last memory element of the memory elements of each memory system is configured to receive a respective signal of the applied signals, the respective signal encoding a sequence of *M* bits. Preferably, each compute unit comprises a set of charge adding units and a corresponding set of switching logics. Namely, each of the compute units comprises *N* charge adding units, which are connected to respective ones of the *N* serially-connected memory elements via respective switching logics.

In preferred embodiments, the method further comprises performing one or more further operations based on the MAC results obtained, thanks to a near-memory digital processing unit connected in output of the readout circuitry, which allows efficient computing for technical computing applications such as machine learning.

Preferably, the method further comprises optimizing bit cardinalities of the *n* groups of bits and the *m* groups of bits with respect to computational precision, latency, and/or energy consumption.

According to another aspect, the invention is embodied as a hardware processing apparatus. The apparatus comprises a memory device and an electronic circuit. The memory device has a crossbar array structure including *K* × *L* cells interconnecting *K* rows and *L* columns. The cells include respective memory systems storing respective N-bit weights. The apparatus includes *K* × *L* compute units, which may advantageously form part of the cells. The compute units are connected to respective ones of the memory systems of the *K* × *L* cells. Again, the compute units are configured as interleaved switched-capacitor analogue multipliers and adders. Consistently with the present methods, the electronic circuit is configured to synchronously apply input signals encoding respective *M*-bit input words to respective ones of the *K* rows, operate the compute units according to a 3-phase clocking scheme, and obtain MAC results for each of the *L* columns, where *K* ≥ 2, *L* ≥ 2, *N* ≥ 2, and *M* ≥ 2.

Moreover, the electronic circuit is further configured to set the clocking scheme to perform *n* × *m* partial multiplications (in the analogue domain) according to a specific bit partition. As explained above, this partition decomposes each of the *N*-bit weights into *n* groups of bits and each of the *M*-bit input words into *m* groups of bits, wherein each of the *n* groups and the *m* groups includes at least one bit, but at least one of the *n* groups and/or the *m* groups includes at least two bits, whereby *N + M > n + m* ≥ 3. The aim is to obtain *n* × *m* partial output signals by each of the compute units. Moreover, the electronic circuit is further configured to obtain the MAC results by summing the partial output signals obtained by the compute units for each of the *L* columns, converting the summed output signals into digital signals encoding partial values, shifting the partial values according to corresponding bit positions set in accordance with the bit partition, and adding the shifted values to recompose the desired output vector components.

As said, the compute units are preferably collocated with the memory systems to which they are connected and form part of the respective cells, whereby the *n* × *m* partial multiplications are performed in-memory, in operation. In variants, the apparatus further comprises a near-memory processing unit, where the latter includes the compute units. The near-memory processing unit may possibly be co-integrated with the crossbar array structure in the memory device.

Preferably, the electronic circuit includes a readout circuitry, which comprises ADCs and digital shit-and-adder circuits. The ADCs are connected in output of respective columns of the compute units, to convert the *n* × *m* partial output signals into the digital signals that encode said partial values, in operation. The digital shit-and-adder circuits are connected in output of respective ones of the ADCs to shift the partial values according to corresponding bit positions set in accordance with the bit partition, and add the shifted values, in operation. The readout circuitry is preferably co-integrated with the crossbar array structure in the memory device.

In embodiments, each of the memory systems of the cells includes serially connected memory elements, e.g., static random-access memory elements. The memory elements are designed to store respective bits of a respective one of the *N*-bit weights, in operation.

Preferably, the electronic circuit further includes an input unit (configured to apply said input signals), as well as control components. The latter are configured to operate the compute units by applying first control signals. The latter include 3-phase signals for implementing the 3-phase clocking scheme. The control components are further configured to operate the readout circuitry to obtain the MAC results. In operation, this is achieved by applying second control signals in phase with the 3-phase signals. The second control signals include first activation signals to activate the ADCs for converting the partial output signals. They further include second activation signals to activate the digital shift-and-adder circuit for shifting the partial values and adding the shifted values.

In preferred embodiments, the apparatus further includes a near-memory digital processing unit, which is preferably cointegrated with the crossbar array structure. The near-memory digital processing unit is connected in output of the readout circuitry and configured to perform operations based on the MAC results obtained at the readout circuitry.

According to another aspect, the invention is embodied as a computing system, which includes one or more hardware processing apparatuses as described above. Preferably, the computing system further comprises a memory unit and a general-purpose processing unit that is connected to the memory unit to read data from, and write data to, the memory unit. Each of the hardware processing apparatuses is configured to read data from, and write data to, the memory unit. The general-purpose processing unit is configured to: map a given computing task to vectors and weights; instruct to store said weights as *N*-bit weights in the cells of any of the hardware processing apparatuses; and instruct to apply input signals encoding vector components of such vectors as *M*-bit input words to rows of any of the hardware processing apparatuses, so as to perform such a computing task, in operation.

### BRIEF DESCRIPTION OF THE DRAWINGS

These and other objects, features and advantages of the present invention will become apparent from the following detailed description of illustrative embodiments thereof, which is to be read in connection with the accompanying drawings. The illustrations are for clarity in facilitating one skilled in the art in understanding the invention in conjunction with the detailed description. In the drawings:
FIG. 1 schematically represents a computerized system, in which a user interacts with a server, via a personal computer, in order to offload matrix-vector product calculations to dedicated hardware accelerators, as in embodiments of the invention;
FIGS. 2 and 3 schematically represent selected components of hardware processing apparatuses including crossbar array structures and compute units, according to embodiments. In FIG. 2, the compute units are collocated with memory systems, to which they are connected; the compute units form part of respective cells of the crossbar array structure. In FIG. 3, the compute units are arranged in a near-memory processing unit, in output of the crossbar array structure;
FIG. 4 schematically illustrates the architecture of an in-memory computing system according to the prior art, see the background section, where the compute units are collocated with memory elements of respective cells of the crossbar array structure;
FIG. 5 schematically illustrates the architecture of an in-memory computing system according to embodiments. As in FIG. 2, the compute units are collocated with memory systems of respective cells of the crossbar array structure. Not only the columns of compute units are connected to analogue-to-digital converters, as in FIG. 4, but, in addition, converters are connected to digital shit-and-adder circuits, to exploit a bit partition that decomposes each *N-*bit weights of the crossbar array structure into *n* groups of bits and each *M*-bit input words into *m* groups of bits;
FIG. 6 is a schematic of compute units corresponding to a same column of the crossbar array structure, as involved in preferred embodiments. Only one compute unit is shown in detail, though. Each compute unit is configured as an interleaved switched-capacitor analogue multiplier and adder;
FIG. 7 is a timing diagram for control signals used in a 3-phase clocking scheme to perform partial multiplications in the analogue domain at each compute unit, as in embodiments. The aim is to enable a bit partition scheme as evoked above;
FIG. 8 illustrates the operation of multi-bit multiplications by compute units as shown in FIG. 6, based on a preferred bit partition, as used in embodiments; and
FIG. 9 is a flowchart illustrating high-level steps of a method of processing data, according to embodiments.

The accompanying drawings show simplified representations of devices or parts thereof, as involved in embodiments. Technical features depicted in FIGS. 2 - 6 are not to scale. Similar or functionally similar elements in the figures have been allocated the same numeral references, unless otherwise indicated.

Apparatuses, systems, and methods, embodying the present invention will now be described, by way of non-limiting examples.

### DETAILED DESCRIPTION OF EMBODIMENTS OF THE INVENTION

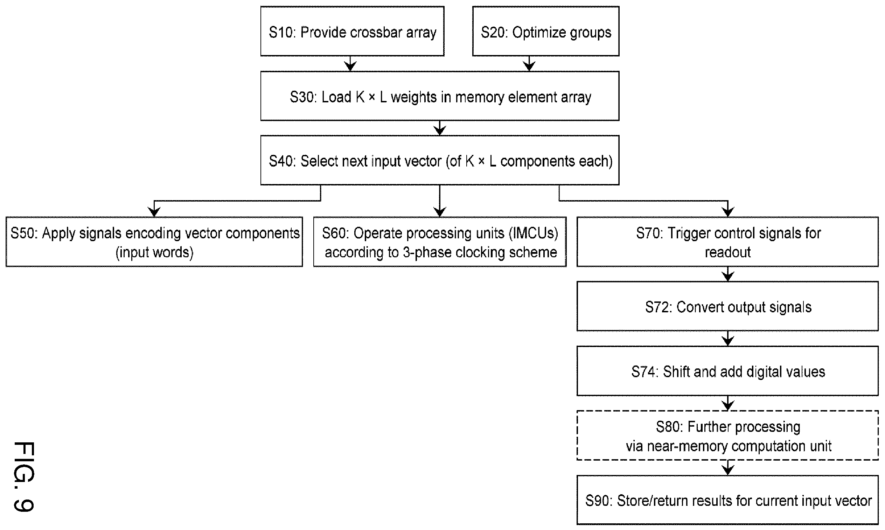

The following description is structured as follows. General embodiments and high-level variants are described in section 1. Section 2 addresses particularly preferred embodiments and technical implementation details. The present method and its variants are collectively referred to as the "present methods". All references Sn refer to methods steps of the flowcharts of FIG. 9, while numeral references pertain to systems, apparatus, devices, components, and concepts, involved in embodiments of the present invention.

### 1. General embodiments and high-level variants

In reference to FIGS. 2, 3, 5, and 9, a first aspect of the invention is now described in detail. This aspect concerns a method of processing data. The method relies on a memory device 10, 10a, which has a crossbar array structure 15, 15a. Examples of such memory devices are shown in FIGS. 2, 3, and 5.

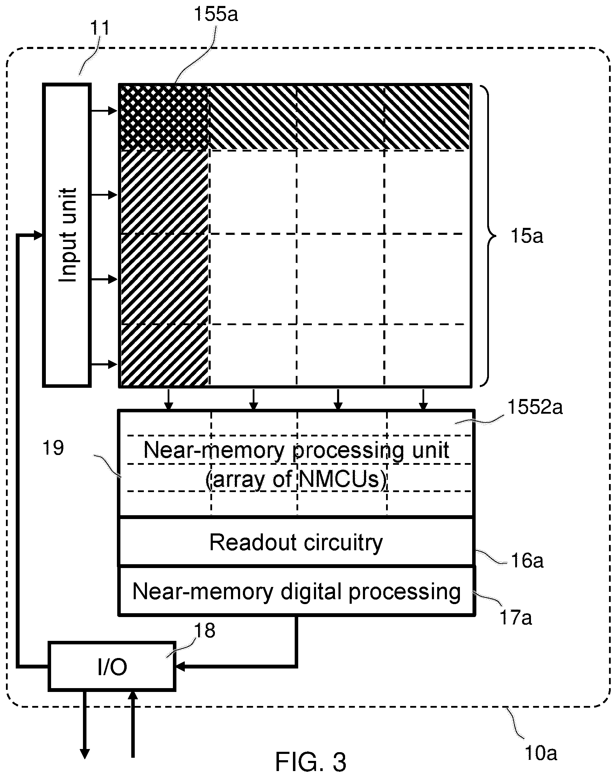

The crossbar array structure 15, 15a includes *K* × *L* cells 155, 155a. In the present document, each cell is defined as a repeating unit that interconnects a row and a column. I.e., the cells interconnect *K* rows and *L* columns, where *K* ≥ 2 and *L* ≥ 2. In FIGS. 2 and 3, the first column is patterned by upward diagonal stripes, while the first row has downward diagonal stripes. A cell corresponds to the intersection of a row and a column. As known *per se,* each row includes one or more input lines and each column includes one or more output lines, which are interconnected at cross-points (i.e., junctions). I.e., each row and each column may in fact involve a plurality of input lines and output lines. In bit-serial implementations, each cell can be connected by a single physical line, which suffices to feed input signals carrying the N-bit input words. In parallel data ingestion approaches, however, parallel conductors may be used to connect to each cell. I.e., bits are injected in parallel via parallel conductors to each of the cells.

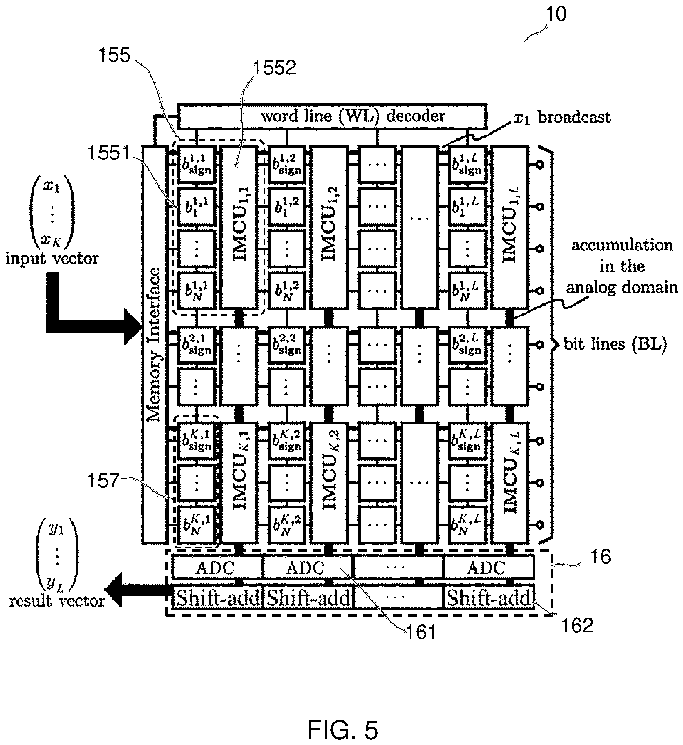

Each cell 155, 155a includes a respective memory system 157, see FIG. 5. The memory systems 157 store respective N-bit weights (*N* ≥ 2), corresponding to matrix elements used to perform matrix-vector multiplications (MVMs). Each memory system 157 preferably includes serially connected memory elements 1551, where such elements store respective bits of the weight stored in the corresponding cell, as illustrated in FIG. 5. The memory elements may for instance be static random-access memory (SRAM) devices. As per the above definitions, each cell corresponds to one cross-point and is assumed to include exactly one memory system 157, which itself may include several memory elements, e.g., SRAM devices. A sub-cell is defined as including exactly one such memory element.

The memory systems 157 are connected to respective compute units (CUs) 1552, 1552a. The CUs may possibly be collocated with the memory systems 157 (i.e., within the crossbar array structure 15, as shown in FIGS. 2 and 5) or be arranged in a near-memory processing unit 19, as assumed in FIG. 3. In each case, the CUs are configured as interleaved switched-capacitor analogue multipliers and adders, similar to the circuit designs proposed in the document PA1 in PA2, subject to differences discussed later.

As in typical IMC architectures, the matrix elements that are stored in the memory systems remain stationary (at least during a given MVM calculation cycle), whereas processing occurs via the CUs. Specifically, the stationary matrix elements (i.e., the weights) are stored in the array of memory systems, while input vector components are fed from the outside to the *L* rows, as illustrated in FIGS. 4 and 5.

The present memory devices 10, 10a are operated as follows. Input signals are synchronously applied to respective rows of the crossbar array 15, 15a, which corresponds to step S50 in the flow of FIG. 9. Such signals encode respective *M*-bit input words, where *M* ≥ 2. Moreover, the CUs are operated (step S60) according to a 3-phase clocking scheme, with a view to obtaining S70 - S74 multiply-accumulate (MAC) results for each of the *L* columns. A 3-phase clocking scheme is a scheme that basically relies on three non-overlapping signals (e.g., signal pulses), which all have the same duration, where the signals are both successively and repeatedly applied, but only one of these signals is applied during a single clock cycle. Such a scheme is discussed in the prior art documents cited in the background section.

However, by contrast with the 3-phase clocking scheme used in the documents PA1 and PA2, here the 3-phase clocking scheme is set to perform partial multiplications in the analogue domain according to a specific bit partition, which can be regarded as a granular bit slicing, involving multi-bit analogue operations. That is, the CUs are operated to perform *n* × *m* partial multiplications, so as to obtain *n* × *m* partial output signals in output of each of the CUs. This partition decomposes each of the N-bit weights into *n* groups of bits. Similarly, it decomposes each of the *M*-bit input words into *m* groups of bits. Still, the numbers (*n* and *m*) of groups are subject to certain constraints, which depart from the schemes proposed in the documents PA1 - PA3. Namely, each of the *n* groups and the *m* groups includes at least one bit but at least one of the *n* groups and/or at least one of the *m* groups includes at least two bits, hence the granular bit slicing evoked above.

In more detail, the numbers (*n* and *m*) of groups are subject to the constraints *N* + *M > n* + *m* ≥ 3. According to the above definitions, at least one of the *n* and *m* groups includes more than one bit, whereby one has either 1 < *n* and 1 ≤ *m*, or 1 ≤ *n* and 1 < *m.* In addition, there are at most *N + M -* 1 groups in total, such that *N* + *M > n + m* ≥ 3. The *n* groups do not need to have the same number of bits as the *m* groups. For example, in preferred embodiments, *m* is strictly less than *M* but strictly more than 1 (e.g., *m* = 2), while *n =* 1. Conversely, *n* may be strictly less than *N* but larger than 1, while *m* = 1.

Plus, the number of bits can vary in each of the *n* groups and/or each of the *m* groups. That is, the number of bits can vary from one of the *n* groups to the other, and/or from one of the *m* groups to the other. The partition can actually be optimized against specific applications, this corresponding to step S20 in the flow of FIG. 9. Thus, various decomposition schemes can be contemplated, as further discussed later in detail.

In the present context, the MAC results are obtained S70 - S74 column-wise, in three steps. First, the partial output signals obtained by the CUs for each of the *L* columns are summed, which operation results from the CU design. The summed output signals are converted S72 into digital signals. The converted signals encode partial values. The latter are shifted S74 according to their corresponding bit positions. I.e., such positions are set in accordance with the bit partition used. Finally, the shifted values are added S74, which leads to the desired result, i.e., a vector component *yⱼ*, where *j =* 1, *..., L,* see the example of FIG. 5.

Comments are in order. In the present context, cells 155, 155a should be distinguished from mere memory systems 157, inasmuch as the cells are connected to CUs 1552, 1552a. The reference 1552 refers to CUs that are collocated with the memory systems 157 in the array 15, as illustrated in FIGS. 2 or 5. In that case, one speaks of in-memory CUs, or IMCUs 1552. In variants, the CUs 1552a are external to the array, yet arranged in close proximity with the memory systems 157, i.e., in a near-memory (analogue) processing unit 19, as assumed in FIG. 3. In that case, the CUs form an array of near-memory CUs (or NMCUs). So, the present CUs 1552, 1552a may form an in-memory compute system or a near-memory compute system, respectively leading to in-memory computing and near-memory computing operations. Thus, in general, the present methods may process data in-memory or using near-memory processing. Preferred is to perform such operations in-memory, in the interest of efficiency and power consumption. However, one may also want to implement the CUs in a near-memory processing unit, be it to be able to reuse existing crossbar array devices.

The bit partition used causes the CUs to perform multibit multiplications as a series of multi-binary multiplication steps. Instead of performing purely binary bit multiplications (as in PA3), at least some of the multiplications involves groups of several bits. That is, a certain granularity is exploited to optimize performance of the MAC operations, by contrast with the solution proposed by PA1, PA2, and PA3. The present bit partitions cause to decompose the multiplication of an input word and a weight as *n* × *m* partial multiplications, based on *n* groups of bits stemming from the stored weight and *m* groups of bits representing the input word. In order words, the signals resulting from the partial multiplications are formed as *n* × *m* partial output signals, for each cell.

If the CUs are internal (i.e., collocated with the memory systems, as in FIG. 2 or 5), the underlying device 10 (or apparatus) forms an in-memory computing device (or apparatus), where each of the *n* × *m* analogue signals outputted from the cells are added in the analogue domain with the corresponding partial output analogue signals of the other CUs on the same column. Then, the added signals are processed in output of each column (e.g., in a respective readout circuitry 16), where they are converted to digital values, shifted in accordance with the bit partition scheme and then summed, in order to reconstruct the expected MAC result of each column.

The scheme is logically similar when the CUs are external (yet connected to the respective memory systems 157), except that data exchanges occur over slightly larger distances, i.e., between the crossbar array 15a and the unit 19 in FIG. 3. In both cases, however, *n* × *m* conversions occur before shifting and adding the signals. In less preferred variants, intermediate conversions can be performed at the level of each cell (or subgroups of cells), which, however, involves additional conversions and thus, additional latency.

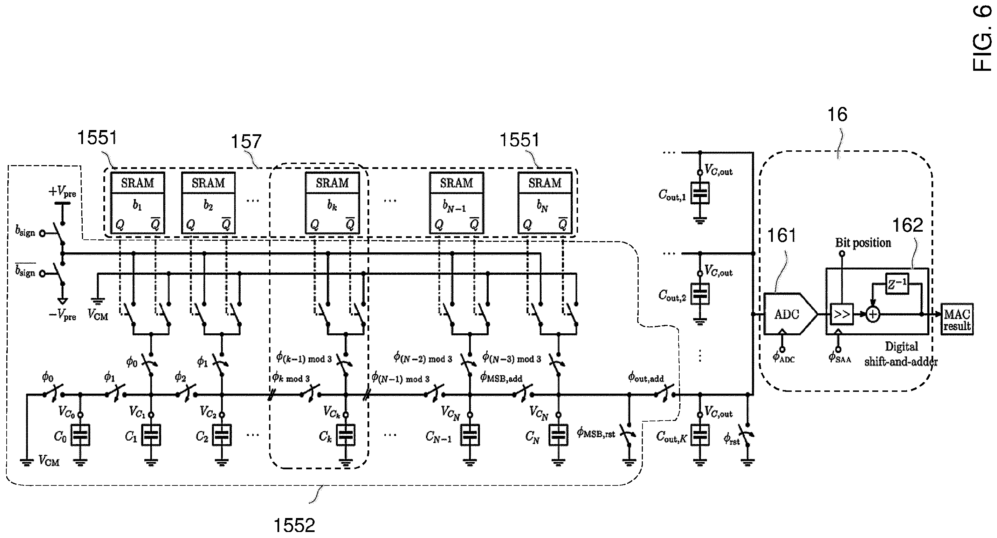

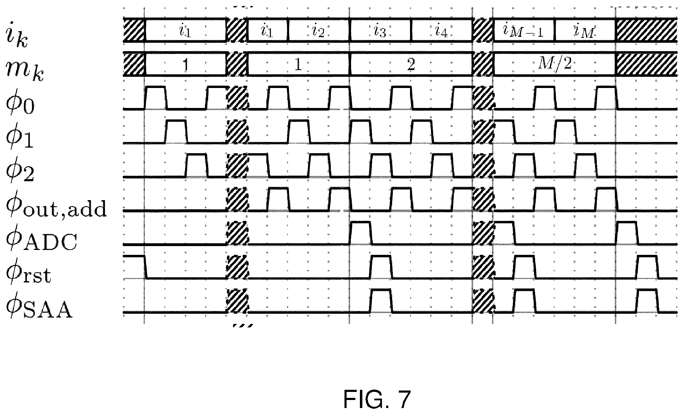

As noted earlier, the underlying device 10, 10a is operated in a synchronous manner, whereby the CUs 1552, 1552a are operated synchronously with the input signals applied. The MAC results are finally obtained by shifting and adding the converted values synchronously with the operation of the CUs. To that aim, use can be made of in-phase control signals. FIG. 6 shows an example of a detailed circuit-level implementation of the CUs, while FIG. 7 shows a possible modulation scheme, which is adjusted to support the granular bit-slicing, while maintaining a full pipelining. FIGS. 6 and 7 are described later in detail.

The above operations may possibly be complemented by further operations executed by a near-memory digital processing unit 17, 17a, connected in output of the readout circuitry 16, 16a. In particular, the present methods may further comprise performing S80 one or more further operations based on the MAC results obtained at step at step S74, thanks to such a near-memory digital processing unit 17, 17a, as assumed in the flow of FIG. 9. Having such a near-memory digital processing unit 17, 17a comes in handy for a number of applications, starting with machine learning applications. Note, the processing unit 17, 17a should be distinguished from the near-memory processing unit 19 implementing NMCUs 1552a, as in embodiments such as shown in FIG. 3.

The underlying device (or apparatus) 10, 10a typically includes an electrical input unit 11 to apply input signals to the input lines forming the rows, as well as other components (e.g., control units, pre-/post-processing units, etc.), which are preferably co-integrated in a single device. Such a device (or apparatus) concerns another aspect of the invention and may notably be used in a computerized system, which concerns a further aspect. These other aspects are addressed later.

To summarize, the present methods describe an analogue MVM implementation for multi-bit weights and inputs, where the analogue multiplication of weights and inputs are performed at a granularity of a defined number of bits at a time. The underlying architecture, which relies on CUs that are configured as interleaved switched-capacitor analogue multipliers and adders, allows an optimized pipeline operation mode. Unlike the multi bit-slicing scheme used in PA3, the presented invention can make full use of pipelining and thus maximize the system throughput.

To fix ideas, PA3 can be regarded as involving *N* × *M* partial multiplications at the cells (where *N* = 4 and *M =* 4). These operations consist of single bit operations, which do not involve any group, unlike the present bit partition. Conversely, the operations performed in the documents PA1 and PA2 can be regarded as involving a single multiplication (*m* = 1 and *n =* 1); the notion of groups and partition are absent in that case. On the contrary, the present approach institutes a bit partition, which results in a granular bit slicing. As it can be realized, this granular bit slicing reduces the analogue compute signal-to-noise ratio (SNR) requirements. At the same time, the proposed approach can maintain the pipeline behaviour of the system (which requires adjusting the pulse modulation scheme), yet without impacting the throughput.

Another aspect of the invention concerns a hardware processing apparatus 10, 10a. Several features of the apparatus have already been described above in reference to the present methods, be it implicitly. Such features are only briefly described in the following.

To start with, the apparatus includes a memory device 10, 10a such as described above. The apparatus notably includes CUs 1552, 1552a, which may form part of the cells, or not. In all cases, the CUs are connected to respective memory systems 157 of the cells and are configured as interleaved switched-capacitor analogue multipliers and adders. Moreover, the apparatus includes an electronic circuit, which is configured to synchronously apply input signals encoding *M*-bit input words to respective rows, operate the CUs 1552, 1552a according to a 3-phase clocking scheme, and obtain MAC results for each of the columns, as discussed above.

Consistently with the present methods, the electronic circuit is further configured to set the clocking scheme, so as for the CUs to perform partial multiplications in the analogue domain according to a specific bit partition, which results in the granular bit slicing described above. The partial multiplications are performed on continuous analogue signals, using analogue processing, as opposed to digital signal processing. For completeness, the electronic circuit causes to obtain the MAC results by: (i) summing the partial output signals obtained by the CUs 1552, 1552a for each column; (ii) converting the summed output signals into digital signals encoding partial values; and (iii) shifting the partial values according to corresponding bit positions (which are set in accordance with the bit partition) and adding the shifted values.

As discussed earlier, the CUs 1552 may advantageously be collocated with the memory systems 157, as assumed in FIG. 2 or 5, or form part of a near-memory processing unit 19, as in FIG. 3. In both cases, the CUs can be regarded as forming *L* columns, whether physically integrated in the cells of the memory device or not. Note, in variants, some of the CUs may possibly be shared across some of the columns.

The near-memory processing unit 19 is preferably co-integrated with the crossbar array structure 15, 15a. The apparatus 10, 10a may further includes additional units, e.g., an input unit 11, a readout circuitry 16, 16a, and a near-memory digital processing unit 17, 17a. In addition, the apparatus 10, 10a will likely include an input/output unit 18, to interface the apparatus with external computers (not shown in FIGS. 2, 3, and 5). This unit 18 is typically a logic circuitry, e.g., a processor or, even, a full computer.

In general, one or more, possibly all, of the above units 11, 17, 17a, 18, 19 may be co-integrated with the crossbar arrays of the devices 10, 10a. So, the apparatus 10, 10a may possibly be embodied as a single, integrated device 10, 10a, should all involved components be co-integrated with the crossbar array 15, 15a. Note, in that respect, the devices 10, 10a shown in FIGS. 2, 3, and 5, are assumed to be integrated devices. E.g., such devices can for instance be implemented as part of application-specific integrated circuit devices.

In embodiments, each memory system 157 of the cells 155, 155a includes serially connected memory elements 1551. The memory elements are designed to store respective bits of a respective N-bit weights, in operation. Preferably, the memory elements 1551 are SRAM elements 1551. Besides SRAM elements, however, other memory technologies can be contemplated, such as technologies relying on sense amplifiers (SA). In particular, the memory elements may be dynamic random-access memory (DRAM) elements. SAs are used to perform local read operations. The SAs do typically not need to have adjustable threshold levels; one single threshold is sufficient to detect zeros or ones. In variants, however, the SAs may have adjustable threshold levels, so as to be able to read several levels. More generally, use can be made of volatile or nonvolatile memory technology. In particular, the memory elements may be binary phase-change memory (PCM) elements, magnetoresistive random access memory (MRAM), or resistive-random access memory (ReRAM). All such memory elements can potentially be used in conjunction with CUs 1552, 1552a described above to provide multibit MAC computing capabilities.

A final aspect concerns a computing system 1, such as depicted in FIG. 1. Such a system 1 includes one or more hardware processing apparatuses 10, 10a (or in fact integral memory devices) such as described above. In the example of FIG. 1, each apparatus is assumed to be a device 10 such as shown in FIG. 2.

In addition, the computing system 1 may typically include a memory unit 2 and a general-purpose processing unit 2, which is connected to the memory unit to read data from, and write data to, the memory unit. In the example of FIG. 1, the memory unit and the general-purpose processing unit are assumed to form part of a same computerized unit 2, e.g., a server computer, which may interact with clients 4, who may be persons (interacting via personal computers 3, as assumed in FIG. 1), processes, or machines.

Each hardware processing apparatus 10 in the system 1 is configured to read data from, and write data to, the memory unit 2. Client requests are managed by the general-purpose processing unit 2, which is notably designed to map a given computing task to vectors and weights. Note, the system 1 may in fact includes a memory system composed of several memory units. Similarly, the system may include several processing units.

The processing unit 2 is notably configured to instruct to store S30 weights as *N*-bit weights in the cells 155 of any of the hardware processing apparatuses 10, 10a involved in the system 1. For completeness, the processing unit 2 can instruct to apply S50 input signals encoding vector components of vectors as *M*-bit input words to rows of any of the hardware processing apparatuses, with a view to performing a computing task. The system 1 may for instance be a composable disaggregated infrastructure, which may include hardware devices 10, 10a as described above along with other hardware acceleration devices, e.g., application-specific integrated circuits (ASICs) and/or field-programmable gate arrays (FPGAs), amongst other possible examples.

### 2. Preferred embodiments

Each of the above aspects is now described in detail, in reference to particular embodiments of the invention. The following notably describes preferred bit partitions (subsection 2.1), hardware processing apparatuses and memory devices (subsection 2.2), architectures of interleaved switched-capacitor analogue multipliers and adders (subsection 2.3), phase signals and 3-phase clocking schemes (subsection 2.4), and an example of high-level flow of operation (subsection 2.5).

### 2.1 Bit partitions

The granularity of the bit partition of the *N*-bit weights and the *M*-bit input words can be asymmetric. That is, the average number of bits of the *n* groups may differ from the average number of bits of the *m* groups. In general, the *n* groups do not need to have a same number of bits, neither do the *m* groups. The bit distributions can possibly be optimized with respect to the desired application. That is, the present methods may attempt to optimize S20 bit cardinalities of the *n* groups of bits and the *m* groups of bits. Such an optimization may for example be performed with respect to computational precision, latency, and/or energy consumption. In some cases, one may want to favour precision (e.g., when accurate vector-matrix multiplications are needed), while applications resilient to precision (e.g., machine learning) may require optimization of latency or energy consumption. Joint optimizations (e.g., against both precision and energy consumption) may further be contemplated, depending on the end user needs.

Even if the groups do not need to have a same number of bits, simpler implementations are achieved by imposing each of the *n* groups to have a same number v of bits and, similarly, each of the *m* groups to have a same number *µ* of bits. Still, v will preferably differ from *µ.* For example, each of the *n* groups (assuming *n* ≥ 2) may include 2 bits, while the *M*-bit input words may each be processed as a single group of *M* bits, i.e., *m* = 1. In that case, only two parameters must be optimized, i.e., *v* and *µ*. Generalizing the above example, the bit partition may possibly be designed to decompose each of the *N*-bit weights into *n* groups of v bits, such that *N* = *n* × v, where *v* ≥ 2, while each of the *M*-bit input words is processed as a single group of *M* bits (*m* = 1).

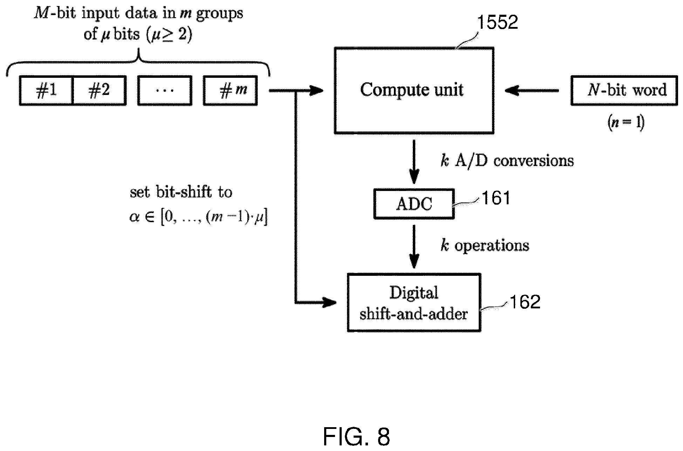

In practice, however, grouping the *N* bits (i.e., imposing *n =* 1) allows an easier CU design, compared to grouping the *M* bits. In that case, each of the *M*-bit input words is decomposed into *m* groups of *µ* bits, such that *M = m* × *µ,* where *µ* ≥ 2, while each N-bit weight is processed as a single group of *N* bits (*n =* 1). An example of such an implementation is shown in FIG. 8. As explained earlier, the analogue multiplications and additions are performed using CUs 1552, 1552a, analogue-to-digital converters (ADCs) 161, and shift-and-add circuitry (amounting to accumulation registers) 162. In the example of FIG. 8, the inputs are applied in *m* groups of *µ* bits, while each weight is operated as a single group of *N* bits, such that each ADC 161 operates *m* times, i.e., *m* conversions are needed at each calculation cycle. The digitized outputs are subsequently shifted according to the relevant bit positions and then accumulated to form the MAC results. The granular bit slicing approach reduces the required analogue compute SNR requirements.

As a final remark, it should be noted that the present methods may possibly use schemes that purposely drop bits, if necessary, independently of the chosen bit partition.

### 2.2 Hardware processing apparatuses and memory devices

As seen in FIGS. 2 and 3, each apparatus (or memory device) 10, 10a includes a crossbar array structure 15, 15a, as well as CUs 1552, 1552a, which are connected to the memory systems 157 of the cells 155, 155a (see also FIGS. 5 and 6). In addition, the apparatus (or memory device) may include an input unit 11, a readout circuitry 16, 16a, a near-memory digital processing 17, 17a, and an input/output (I/O) unit 18. As explained earlier, such components may be cointegrated with the array 15, 15a, to form an integrated device 10, 10a.

The example of device 10 shown in FIGS. 2 and 5 assume that the CUs 1552 are collocated with the memory systems 157 to which they are connected. Each memory system 157 includes *N* serially-connected memory elements 1551, e.g., SRAM elements, each storing a respective bit of the corresponding N-bit weight. An additional memory element is typically used to store the sign of the weight. In such embodiments the CUs 1552 form part, physically, of the cells 155. Thus, each CU 1552 is an IMCU, which performs *n* × *m* partial multiplications, in-memory, at each calculation cycle. As further seen in FIGS. 2 and 5, the MAC results are obtained S70 - S74 via a readout circuitry 16, which is preferably co-integrated with the crossbar array structure 15 in the memory device 10. The readout circuitry 16 includes ADCs 161 that are connected to a respective column of the array 15 for converting the partial output signals as summed for each column into digital signals. Digital shift-and-adder circuits 162 complete the device 10. The circuits 162 are connected in output of respective ADCs 161 for shifting the partial values and adding the shifted values, in accordance with relevant bit positions thereof.

Every CU 1552 in a particular column produces *n* × *m* partial output signals that are individually summed in the analogue domain. That is, each of the *n* × *m* partial signals is summed with a corresponding one of the *n* × *m* partial signals produced by the previous CU in the same column (except, of course for the very first CU in that column). Accordingly, *n* × *m* partial, accumulated signals are obtained in output of each column. Such output signals are then converted to digital signals by a corresponding ADC 161, prior to being shifted and added via the component 162. The conversion, shift, and add operations, occur in output of each column. In less preferred variants, intermediate conversions may possibly be performed, e.g., at the level of each cell or each subset of cells. This, however, requires adding ADC converters in output of (subsets of) cells concerned, as noted earlier.

In variants, the CUs 1552a may form part of a near-memory processing unit 19, which is preferably co-integrated with the crossbar array structure 15a, to form a device 10a. In both cases, the ADCs 161 are connected to respective columns of the CUs, i.e., whether collocated with the memory systems or not. Thus, the operations remain the same, logically speaking, except that signals must be conveyed over slightly larger distances in the example of the device 10a. Operations performed in the near-memory processing unit 19 are still performed as analogue operations, contrary to operations performed by the near-memory digital processing unit 17, 17a.

As further seen in FIGS. 2 and 3, the near-memory digital processing unit 17, 17a is directly connected in output of the readout circuitry 16, 16a. The unit 17, 17a can be used to perform digital operations based on the MAC results obtained at the readout circuitry 16, 16a, which allows efficient computing for technical computing applications such as machine learning.

### 2.3 Interleaved switched-capacitor analogue multipliers and adders

As illustrated in FIG. 6, each CU is configured as an interleaved switched-capacitor analogue multiplier and adder 1552. Each CU 1552 is connected to a respective memory system 157, which, in this example, includes serially connected SRAM memory elements 1551, storing respective bits.

Each CU 1552 includes charge adding units (capacitors in the example of FIG. 6), which are connected to the memory elements via switching logics. Each switching logic includes three switches in the example of FIG. 6. A column of CUs is serially connected to an output block 16, which includes an ADC 161 and a shift-and-adder 162. So, each cell 155 comprises several memory elements 1551, several switching logics, and several capacitors. Each sub-cell corresponds to a single memory element, which connects to a respective capacitor via a respective switching logic. Again, a cell is here considered to include a memory system 157 (i.e., including several memory elements). By contrast, in PA2, a cell is defined as corresponding to a single memory element.

The last memory element 1551 (corresponding to *C_{N}* in FIG. 6) of the memory system 157 is configured to receive the signal encoding the sequence of *M* bits. I.e., it receives a stream of *M* bits via the source.

Each switching logic is configured such that the corresponding capacitor can be pre-charged or charged (e.g., from another capacitor) in response to the application of a clock signal at the switching logic. In addition, each switching logic can connect its respective capacitor to its respective memory element in response to another clock signal applied at the switching logic.

Beyond the operation of the compute units shown in FIG. 6, which in the present case obey a certain bit partition logic, there are several differences between the design shown in FIG. 6 and the schematic proposed in Fig. 2 of PA1 and the schematics disclosed in PA2. First, the design proposed in FIG. 6 relies on readout circuitry 16 that involves both an ADC 161 and a shift-and-adder circuit 162, unlike PA1 and PA2. Moreover, the compute units also differ in that they do not require a switch for the accumulation that is driven by the signal *ϕ*_{ACC} in PA1, which basically saves one switch at every cross-point.

### 2.4 Phase signals and 3-phase clocking scheme

The CUs 1552, 1552a are operated thanks to a 3-phase clocking scheme, which is similar to the schemes presented in PA1 and PA2, subject to differences that are discussed now in detail. That is, the control signal scheme is here adapted to the bit partition used, as well as to the shift-and-add operations.

Several types of control signals can be involved. The CUs 1552, 1552a can notably be operated S60 thanks to first control signals, which include the 3-phase signals (noted *ϕ*₀, *ϕ*₁, and *ϕ*₂ below) used for implementing the 3-phase clocking scheme, which is similar to the scheme discussed in PA1.

In detail, and as seen in FIG. 7, the 3-phase clocking scheme spans a sequence of clock cycles, where the sequence actually decomposes into *M* sets of clock cycles, corresponding to sets *i*₁, *i*₂, *..., i_{M}* in FIG. 7. Each of the *M* sets includes at least three clock cycles. The *M* sets are associated with respective *M* bits of the M-bit input words. The 3-phase signals (*ϕ*₀, *ϕ*₁, and *ϕ*₂) are repeatedly applied, *M* times, during the *M* sets of clock cycles. The 3-phase signals are successively applied during three clock cycles: only one phase signal of the 3-phase signals is applied during one clock cycle (i.e., a single cycle of the three clock cycles). In other words, a triplet of signal pulses is repetitively applied, in accordance with the *M* sets of clock cycles, but the three signals of each triplet are successively applied during a single set of clock cycles (corresponding to one of the *M* sets of clock cycles), meaning that only one pulse is applied during a single clock cycle, hence the name of "3-phase clocking scheme".

Note, however, that the very first set of the *M* sets of clock cycles (corresponding to the set *i*₁ in FIG. 7) may possibly require more than three clock cycles, to allow a steady state to be achieved, as also described in PA1. Yet, the subsequent sets of clock cycles consist of three cycles only. Thus, in such scenarios, the sets of clock cycles include at least three clock cycles; they mostly consist of three clock cycles only, except the very first set *i*₁ of clock cycles.

In addition to the first control signals, second control signals may be used to obtain S70 - S74 the MAC results. As reflected in the flow of FIG. 9, the second control signals are applied at step S70. Such signals are applied in phase with the 3-phase signals, so as to enable a synchronous operation of the CUs 1552, 1552a and the readout circuitry 16, 16a. "In phase" means that rising and falling edges of the second control signals occur in sync with either of the 3-phase signals *ϕ*₀, *ϕ*₁, and *ϕ*₂.

In embodiments, the second control signals includes signals noted *ϕ*_{MSB,add}, *ϕ*_{MSB,rst}, *ϕ*_{out,add}, *ϕ*_{ADC}, *ϕ*ᵣₛₜ, and *ϕ*_{SAA}. These decompose into input-bit dependent signals (*ϕ*_{MSB,add}, *ϕ*_{MSB,rst}, and *ϕ*_{out,add}) and group-dependent signals (*ϕ*_{ADC}, *ϕ*ᵣₛₜ, and *ϕ*_{SAA}). Note, *ϕ*_{ADC} corresponds to the signal noted *ϕ*_{SMP} in PA1.

While the periodicity of the input-bit dependent signals matches that of the first control signals, the periodicity of the group-dependent control signals does differ. Specifically, the group-dependent control signals span a sequence of clock cycles, whose sequence decomposes into *m* sets of clock cycles. The example in FIG. 7 assumes *m = M*/2 and illustrates the group-dependency with the counter value *mₖ* that indicates the number of the group, which is currently processed.

The signals *ϕ*_{MSB,rst} and *ϕ*_{MSB,add} work as in PA1. They are applied to respectively discharge the capacitor *C_{N}* (see FIG. 6) to 0, when the input bit is 0, and perform charge-sharing with the previous capacitor *C*_{*N* - 1} to generate a weight-proportional voltage on *C_{N}* in accordance with an input bit of 1. The signal *ϕ*_{out,add} is subsequently applied to accumulate the result on the last capacitor. The 3 input-dependent signals *ϕ*_{MSB,add}, *ϕ*_{MSB,rst} and *ϕ*_{out,add} are only active after the CU is in steady-state, see the timing diagram (Fig. 4) of PA1.

In the present context, however, the second control signals include the additional, group-dependent signals *ϕ*_{ADC}, *ϕ*_{SAA}, and *ϕᵣₛₜ.* The latter include two types of activation signals, hereafter called first activation signals (noted *ϕ*_{ADC}) and second activation signals (noted *ϕ*_{SAA}). The first activation signals *ϕ*_{ADC} are applied to activate S72 the ADCs 161, for the ADCs to convert the partial output signals into digital signals. The second activation signals *ϕ*_{SAA} are used to activate S74 the digital shift-and-adder circuits 162, for the latter to shift the partial values and add the shifted values. The signal *ϕᵣₛₜ* is used to reset the output capacitors' voltage *V*_{C,out} to 0 (corresponding to the output capacitors noted *C*_{out,1} to *C*_{out,*K*} in FIG. 6).

The operation of the activation signals is as follows. As seen in FIGS. 6 and 7, the activation signal *ϕ*_{ADC} is applied to the ADC 161, for it to convert current partial output signals into digital signals. The signal *ϕ*_{ADC} activates the ADC 161 taking into account the sampling clock of the ADC in output of each column. Next, *ϕ*_{SAA} is applied to activate S74 the circuit 162, whereby the bit position ("Bit position" in FIG. 6) is fed to the element 162 to execute the shift-and-add operation. This position can be set as a bit shift, as noted in FIG. 8. In the example of FIG. 8, the bit-shift position (corresponding to the signal "Bit position" in FIG. 6) fed to the unit 162 ranges from 0 to *(m* - 1)·*µ*, because the bit partition is assumed to decompose each M-bit input word into *m* groups of *µ* bits, where *M* = *m* × *µ* and *µ* ≥ 2, while each N-bit weights is processed as a single group of *N* bits (*n* = 1) in this example.

Every time the input bits of an input-bit group have been processed, the three signals *ϕ*_{ADC}, *ϕ*_{SAA}, and *ϕᵣₛₜ* are strobed one by one - for *m* groups of input bits this happens *m* times, after which the operation is completed. Note, the position of input bits and weight bits can be swapped for grouping weight bits instead of input words. As noted earlier, the signals *ϕ*_{SAA} and *ϕᵣₛₜ* are applied in-phase with the 3-phase signals.

Additional signals may be used, which are not shown in FIG. 7, starting with helper signals to generate other signals such as *ϕ*_{MSB,rst}, see for example PA1.

As in PA1, some signals are common for the entire array 15, for instance the 3-phase signals *ϕ*₀, *ϕ*₁, *ϕ*₂, as well as *ϕ*_{out,add}. Other signals, such as the signal pair of *ϕ*_{MSB,add} and *ϕ*_{MSB,rst}, are generated for each row depending on the input vector bits. The signals *ϕ*₀, *ϕ*₁, *ϕ*₂ are active throughout the whole operation. In variants, the signals *ϕ*₀, *ϕ*₁, *ϕ*₂ may occasionally be turned off, e.g., for a few cycles, when the input bits are 0, in order to save energy.

As evoked earlier, each memory system may include *N* serially-connected memory elements 1551, each storing a respective bit of the corresponding N-bit weight. The last memory element 1551 (corresponding to bit *b_{N}* and capacitor C*_{N}* in FIG. 6) of each memory system 157 can be configured in the cell to receive a respective signal, which encodes a sequence of *M* bits. In variants, more than one element may receive the input-dependent signals. In other variants, the element that receives the input-dependent signals is not the last element but is the element that encodes the MSB that receives the input-dependent signals. However, the circuit is preferably configured in such a manner that the last memory element of a column receives the input-dependent signals, which allows an easier implementation.

Basically, each bit of the stream of *M* bits received at the last memory element is associated with a respective group of clock cycles, as per the 3-phase clocking scheme discussed above, which results in a sequence of *M* groups of cycles. By performing a successive and repetitive pipelined application of the 3-phase signals during a given one of the *M* groups, a phase signal is applied during each cycle of the given group. This allows the CU 1552 to map digital values stored in each memory element into a word proportional voltage, and to transfer the word proportional voltages of the capacitors C₁ to C_{*N* - 1} to the last capacitor *C_{N}* such that the voltage V*_{CN}* across the last capacitor C*_{N}* is the analogue voltage that corresponds to the N-bit word scaled by the bit associated with that group. The output block 16 adequately reconstructs the expected value based on the bit positions corresponding to the groups used in the bit partition.

As explained earlier, each CU 1552 preferably comprises *N* charge adding units, which are connected to respective memory elements 1551 via respective switching logics, see FIG. 6. For example, assume that the chosen bit partition decomposes each *M*-bit input word into *m* groups of *µ* bits (i.e., *M* = *m* × *µ, µ* ≥ 2) and that each *N*-bit weight is processed as a single group of *N* bits (*n* = 1). In that case, the *m* groups impact the application of the signals *ϕ*_{ADC}, *ϕ*ᵣₛₜ, and *ϕ*_{SAA}. Such signals are successively applied during the clock cycles to generate a voltage across the charge adding unit of the last memory element (corresponding to *b_{N}* and C*_{N}*), which corresponds to the *N*-bit word scaled by a bit value of a respective one of the *µ* bits within each of the *m* groups.

### 2.5 Preferred flow

A preferred flow is shown in FIG. 9. First, a memory device with a crossbar array is provided at step S10. Parameters of an optimal bit partition are loaded at step S20, e.g., in accordance with a client request (not shown) aiming at performing a given computation task involving a matrix-vector product. Bit partitions are assumed to have already been optimized against a variety of applications. At step S30, weights (matrix coefficients) are loaded in the memory systems 157. An input vector of *K* components is selected at step S40. Corresponding input signals are applied at step S50, which encode the vector components (input words). Meanwhile, the CUs are operated S60 according to a 3-phase clocking scheme as described above. Control signals are concurrently triggered at step S70 for readout purposes. These notably cause the ADCs 161 to convert S72 signals obtained for each column and the components 162 to shift and add S74 the digital values obtained, all these in accordance with the loaded bit partition parameters. Optionally, a near-memory digital processing unit is used to further process S80 the MAC results. Any intermediate result can be locally stored S90 or returned. The above steps can be repeated for any required matrix-vector calculation.

### 3. Final remarks

Computerized devices 10, 10a and systems 1 can be suitably designed for implementing embodiments of the present invention as described herein. In that respect, it can be appreciated that the methods described herein are essentially non-interactive, i.e., automated. Automated parts of such methods can be implemented in hardware only, or as a combination of hardware and software. In exemplary embodiments, automated parts of the methods described herein are implemented in software, which is executed by suitable digital processing devices. In particular, the methods described herein may involve executable programs, scripts, or, more generally, any form of executable instructions, be it to instruct to perform core computations at the devices 10, 10a. The required computer readable program instructions can for instance be downloaded to processing elements from a computer readable storage medium, via a network, for example, the Internet and/or a wireless network. However, all embodiments described here involve analogue computations performed thanks to crossbar array structures and compute units described in sections 2 and 3.

While the present invention has been described with reference to a limited number of embodiments, variants, and the accompanying drawings, it will be understood by those skilled in the art that various changes may be made, and equivalents may be substituted without departing from the scope of the present invention. In particular, a feature (device-like or method-like) recited in a given embodiment, variant or shown in a drawing may be combined with or replace another feature in another embodiment, variant, or drawing, without departing from the scope of the present invention. Various combinations of the features described in respect of any of the above embodiments or variants may accordingly be contemplated, that remain within the scope of the appended claims. In addition, many minor modifications may be made to adapt a particular situation or material to the teachings of the present invention without departing from its scope. Therefore, it is intended that the present invention is not limited to the particular embodiments disclosed, but that the present invention will include all embodiments falling within the scope of the appended claims. In addition, many other variants than explicitly touched above can be contemplated. For example, other types of memory elements can be contemplated.

## Claims

1. A method of processing data, the method comprising:
providing (S10) a memory device (10, 10a) having a crossbar array structure (15) including *K* × *L* cells (155, 155a) interconnecting *K* rows (151, 151a) and *L* columns, the cells including respective memory systems storing respective *N*-bit weights, wherein the memory systems are connected to respective compute units (1552, 1552a), which are configured as interleaved switched-capacitor analogue multipliers and adders; and
synchronously applying (S50) input signals encoding respective *M*-bit input words to respective ones of the *K* rows, operating (S60) the compute units according to a 3-phase clocking scheme, and obtaining (S70 - S74) multiply-accumulate results for each of the *L* columns, where *K* ≥ 2, *L* ≥ *2, N* ≥ 2, and *M* ≥ 2,
wherein
the 3-phase clocking scheme is set to perform *n* × *m* partial multiplications, in the analogue domain, according to a bit partition decomposing each of the *N-bit* weights into *n* groups of bits and each of the *M-bit* input words into *m* groups of bits, wherein each of the *n* groups and the *m* groups includes at least one bit, but at least one of the *n* groups and/or the *m* groups includes at least two bits, whereby *N + M > n + m* ≥ 3, so as to obtain *n* × *m* partial output signals, and
the multiply-accumulate results are obtained (S70 - S74) by summing the partial output signals obtained by the compute units (1552, 1552a) for each of the *L* columns, converting (S72) the summed output signals into digital signals encoding partial values, shifting (S74) the partial values according to corresponding bit positions set in accordance with the bit partition, and adding (S74) the shifted values.

2. The method according to claim **1,** wherein
a granularity of the bit partition of the *N-bit* weights and the *M-bit* input words is asymmetric, whereby an average number of bits of the *n* groups differs from an average number of bits of the *m* groups.

3. The method according to claim **2,** wherein
each of the *n* groups has a same number v of bits and each of the *m* groups has a same number *µ* of bits, where *v* differs from *µ.*

4. The method according to claim 3, wherein the bit partition is designed so as to either decompose
each of the *N-bit* weights into *n* groups of v bits, such that *N* = *n* × v, where *v* ≥ 2, and each of the *M-bit* input words into a single group of *M* bits, whereby *m =* 1, or
each of the *M-bit* input words into *m* groups of *µ* bits, such that *M* = *m* × *µ*, where *µ* ≥ 2, and each of the *N-bit* weights into a single group of *N* bits, whereby *n* = 1.

5. The method according to claim **1,** wherein
the compute units (1552, 1552a) are collocated with the respective memory systems to which they are connected and form part of the respective cells (155), whereby the *n* × *m* partial multiplications are performed in-memory in the memory device (10).

6. The method according to any one of claims **1** to **5,** wherein
the multiply-accumulate results are obtained (S70 - S74) via a readout circuitry (16, 16a), which includes:
analogue-to-digital converters (161) connected to respective columns of the compute units (1552, 1552a) for converting the partial output signals as summed for each of the *L* columns into the digital signals; and
digital shift-and-adder circuits (162) connected in output of respective ones of the analogue-to-digital converters (161) for shifting the partial values and adding the shifted values, and
the readout circuitry (16) is preferably co-integrated with the crossbar array structure (15) in the memory device (10, 10a).

7. The method according claim 6, wherein
the compute units (1552, 1552a) are operated (S60) thanks to first control signals, which include 3-phase signals for implementing the 3-phase clocking scheme, and
the multiply-accumulate results are obtained (S70 - S74) by applying (S70) second control signals, which are in phase with the 3-phase signals, so as to enable a synchronous operation of the compute units (1552, 1552a) and the readout circuitry (16, 16a), the second control signals including:
first activation signals to activate (S72) the analogue-to-digital converters (161) for converting the partial output signals, and
second activation signals to activate (S74) the digital shift-and-adder circuits (162) for shifting the partial values and adding the shifted values.

8. The method according claim **1,** wherein
the 3-phase clocking scheme spans a sequence of clock cycles, wherein the sequence decomposes into *M* sets of clock cycles associated with respective *M* bits of the *M-bit* input words,
the 3-phase signals are repeatedly applied, *M* times, during the *M* sets of clock cycles, and
each of the *M* sets includes three clock cycles, during which the 3-phase signals are successively applied, such that only one phase signal of the 3-phase signals is applied during a single one of the three clock cycles.

9. The method according to claim **8,** wherein
each memory system of the memory systems of each cell of the *K* × *L* cells (155, 155a) consists of *N* serially-connected memory elements (1551), each storing a respective bit of one of the *N* bits of the *N-bit* weights that is stored in said each cell, wherein a last memory element of the memory elements (1551) of said each memory system is configured to receive a respective signal of the applied signals, the respective signal encoding a sequence of *M* bits, and
each of the compute units (1552, 1552a) preferably comprises *N* charge adding units, which are connected to respective ones of the *N* serially-connected memory elements via respective switching logics.

10. A hardware processing apparatus (10, 10a), comprising
a memory device (10, 10a) having a crossbar array structure (15) including *K* × *L* cells (155, 155a) interconnecting *K* rows (151, 151a) and *L* columns, the cells including respective memory systems storing respective N-bit weights,
*K* × *L* compute units (1552, 1552a) connected to respective ones of the memory systems of the *K* × *L* cells, wherein the compute units are configured as interleaved switched-capacitor analogue multipliers and adders; and
an electronic circuit configured to synchronously apply input signals encoding respective *M-bit* input words to respective ones of the *K* rows, operate the compute units (1552, 1552a) according to a 3-phase clocking scheme, and obtain multiply-accumulate results for each of the *L* columns, where *K* ≥ 2, *L* ≥ 2, *N* ≥ 2, and *M* ≥ 2,
wherein the electronic circuit is further configured to
set the clocking scheme to perform *n* × *m* partial multiplications, in the analogue domain, according to a bit partition decomposing each of the *N-bit* weights into *n* groups of bits and each of the *M-bit* input words into *m* groups of bits, wherein each of the *n* groups and the *m* groups includes at least one bit, but at least one of the *n* groups and/or the *m* groups includes at least two bits, whereby *N* + *M* > *n* + *m* ≥ 3, so as to obtain *n* × *m* partial output signals, and
obtain the multiply-accumulate results by summing the partial output signals obtained by the compute units (1552, 1552a) for each of the *L* columns, converting the summed output signals into digital signals encoding partial values, shifting the partial values according to corresponding bit positions set in accordance with the bit partition, and adding the shifted values, and
wherein, preferably, the apparatus further includes
a near-memory digital processing unit (17, 17a), which is preferably cointegrated with the crossbar array structure (15, 15a), wherein the near-memory digital processing unit (17, 17a) is connected in output of the readout circuitry (16) and configured to perform operations based on the multiply-accumulate results obtained at the readout circuitry (16).

11. The apparatus (10) according to claim **10,** wherein
the compute units (1552, 1552a) are collocated with the memory systems to which they are connected and form part of the respective cells (155), whereby the *n* × *m* partial multiplications are performed in-memory, in operation.

12. The apparatus (10, 10a) according to claim **10,** wherein
the apparatus (10, 10a) further comprises a near-memory processing unit (19), where the latter includes the compute units, and
the near-memory processing unit (19) is preferably co-integrated with the crossbar array structure (15, 15a) in the memory device (10, 10a).

13. The apparatus (10, 10a) according to claim **10, 11,** or **12,** wherein
the electronic circuit includes a readout circuitry (16, 16a), which comprises
analogue-to-digital converters (161) connected in output of respective columns of the compute units (1552, 1552a), to convert the *n* × *m* partial output signals into the digital signals that encode said partial values, in operation; and
digital shit-and-adder circuits connected in output of respective ones of the analogue-to-digital converters (161) to shift the partial values according to corresponding bit positions set in accordance with the bit partition, and add the shifted values, in operation,
the readout circuitry (16, 16a) is preferably co-integrated with the crossbar array structure (15, 15a) in the memory device (10, 10a), and
each of the memory systems of the cells (155, 155a) preferably includes serially connected memory elements (1551), the latter designed to store respective bits of a respective one of the N-bit weights, in operation, the memory elements (1551) being preferably static random-access memory elements.

14. The apparatus (10, 10a) according to claim **13,** wherein the electronic circuit further includes:
an input unit (11) configured to apply said input signals; and
control components configured to operate
the compute units (1552, 1552a) by applying first control signals that include 3-phase signals for implementing the 3-phase clocking scheme, and
the readout circuitry (16, 16a) to obtain the multiply-accumulate results by applying second control signals in phase with the 3-phase signals, wherein, in operation, the second control signals include
first activation signals to activate the analogue-to-digital converters (161) for converting the partial output signals, and
second activation signals to activate the digital shift-and-adder circuit (162) for shifting the partial values and adding the shifted values.

15. A computing system (1) comprising:
one or more hardware processing apparatuses, each according to any one of claims **10** to **14;**
a memory unit (2); and
a general-purpose processing unit (2) connected to the memory unit to read data from, and write data to, the memory unit,
wherein
each of the hardware processing apparatuses (10, 10a) is configured to read data from, and write data to, the memory unit, and
the general-purpose processing unit is configured to
map a given computing task to vectors and weights,
instruct to store (S30) said weights as *N*-bit weights in the cells (155, 155a) of any of the hardware processing apparatuses, and
instruct to apply (S50) input signals encoding vector components of such vectors as *M*-bit input words to rows of any of the hardware processing apparatuses, so as to perform such a computing task, in operation.

## Patentansprüche

1. Ein Verfahren zur Datenverarbeitung, wobei das Verfahren umfasst:
Bereitstellen (S10) einer Speichervorrichtung (10, 10a) mit einer Kreuzgitterstruktur (15), die *K* × *L* Zellen (155, 155a) umfasst, die *K* Reihen (151, 151a) und *L* Spalten miteinander verbinden, wobei die Zellen jeweilige Speichersysteme umfassen, die jeweilige Gewichte von *N* Bits speichern, wobei die Speichersysteme mit jeweiligen Recheneinheiten (1552, 1552a) verbunden sind, die als verschachtelte analoge Kondensator-Multiplizierer und - Addierer konfiguriert sind; und
synchrones Anlegen (S50) von Eingangssignalen, die jeweilige M-Bit-Eingangswörter an jeweilige Reihen der *K* Reihen codieren, Betreiben (S60) der Recheneinheiten gemäß einem 3-Phasen-Taktschema und Erhalten (S70 - S74) Multiplikations-Akkumulationsergebnisse für jede der *L* Spalten, wobei *K* ≥ 2, *L* ≥ *2, N* ≥ 2 und *M* ≥ 2,
wobei
das 3-Phasen-Taktschema so eingestellt ist, dass es *n* × *m* Teilmultiplikationen im analogen Bereich gemäß einer Bitaufteilung durchführt, die jedes der N-Bit-Gewichte in *n* Bitgruppen und jedes der M-Bit-Eingangswörter in *m* Bitgruppen zerlegt, wobei jede der *n* Gruppen und *m* Gruppen mindestens ein Bit umfasst, aber mindestens eine der *n* Gruppen und/oder *m* Gruppen mindestens zwei Bits umfasst, sodass *N* + *M > n* + *m* ≥ 3 ist, um *n* × *m* Teilausgangssignale zu erhalten, und
die Ergebnisse der Multiplikations-Akkumulation erhalten werden (S70 - S74), indem die von den Recheneinheiten (1552, 1552a) für jede der *L* Spalten erhaltenen Teilausgangssignale addierten werden, Umwandeln (S72) der addierten Ausgangssignale in digitale Signale, die Teilwerte codieren, Verschieben (S74) der Teilwerte entsprechend den gemäß der Bitpartition definierten Bitpositionen und Addieren (S74) der verschobenen Werte.

2. Das Verfahren nach Anspruch **1,** wobei
eine Granularität der Bitpartitionierung der N-Bit-Gewichte und der M-Bit-Eingangswörter asymmetrisch ist, wobei sich eine durchschnittliche Anzahl von Bits der *n* Gruppen von einer durchschnittlichen Anzahl von Bits der *m* Gruppen unterscheidet.

3. Das Verfahren nach Anspruch **2** , wobei
jede der *n* Gruppen eine gleiche Anzahl v von Bits und jede der *m* Gruppen eine gleiche Anzahl *µ* von Bits aufweist, wobei v sich von *µ* unterscheidet.

4. Das Verfahren nach Anspruch **3,** wobei die Bitpartitionierung so ausgelegt ist, dass sie entweder
jedes der N-Bit-Gewichte in *n* Gruppen von v Bits zerlegt, sodass *N* = *n* × v, wobei *v* ≥ 2, und jedes der M-Bit-Eingangswörter in eine einzige Gruppe von *M* Bits, sodass *m* = 1, oder
jedes der M-Bit-Eingangswörter mit in *m* Gruppen mit *µ* Bits zerlegt, sodass *M* = *m* × *µ*, wobei *µ* ≥ 2, und jedes der N-Bit-Gewichte in eine einzige Gruppe mit *N* Bits, wobei *n* = 1.

5. Das Verfahren nach Anspruch **1,** wobei
die Recheneinheiten (1552, 1552a) zusammen mit den jeweiligen Speichersystemen, mit denen sie verbunden sind, an einem Ort angeordnet sind und Teil der jeweiligen Zellen (155) sind, so dass die *n* × *m* Teilmultiplikationen im Speicher der Speichervorrichtung (10) durchgeführt werden.

6. Das Verfahren nach einem der Ansprüche **1** bis **5,** wobei
die Multiplikations-Akkumulationsergebnisse (S70 - S74) über eine Ausleseschaltung (16, 16a) erhalten werden, die umfasst:
Analog-Digital-Wandler (161), die mit den jeweiligen Spalten der Recheneinheiten (1552, 1552a) verbunden sind, um die für jede der *L* Spalten addierten Teilausgangssignale in digitale Signale umzuwandeln; und
digitale Verschiebe- und Additionsschaltungen (162), die mit dem Ausgang der jeweiligen Analog-Digital-Wandler (161) verbunden sind, um die Teilwerte zu verschieben und die verschobenen Werte zu addieren, und
die Ausleseschaltung (16) vorzugsweise gemeinsam mit der Kreuzgitterstruktur (15) in der Speichervorrichtung (10, 10a) integriert ist.

7. Das Verfahren nach Anspruch **6,** wobei
die Recheneinheiten (1552, 1552a) durch erste Steuersignale betrieben werden (S60), die dreiphasige Signale zur Umsetzung des dreiphasigen Taktschemas umfassen, und
die Multiplikations-Akkumulationsergebnisse erhalten werden (S70 - S74), indem zweite Steuersignale angelegt werden (S70), die mit den dreiphasigen Signalen phasengleich sind, um einen synchronen Betrieb der Recheneinheiten (1552, 1552a) und der Ausleseschaltungen (16, 16a) zu ermöglichen, wobei die zweiten Steuersignale umfassen:
erste Aktivierungssignale zum Aktivieren (S72) der Analog-Digital-Wandler (161), um die Teilausgangssignale zu konvertieren, und
zweite Aktivierungssignale zum Aktivieren (S74) der digitalen Verschiebe- und Additionsschaltungen (162), um die Teilwerte zu verschieben und die verschobenen Werte zu addieren.

8. Das Verfahren nach Anspruch **1,** wobei
das dreiphasige Taktschema eine Folge von Taktzyklen abdeckt, wobei die Folge in *M* Sätze von Taktzyklen unterteilt ist, die jeweiligen *M* Bits der M-Bit-Eingangswörter zugeordnet sind,
die dreiphasigen Signale wiederholt während der *M* Sätze von Taktzyklen M-mal angelegt werden, und
jede der M-Gruppen drei Taktzyklen umfasst, während denen die dreiphasigen Signale nacheinander angelegt werden, sodass nur ein einziges dreiphasiges Signal unter den dreiphasigen Signalen während nur einem der drei Taktzyklen angelegt wird.

9. Das Verfahren nach Anspruch **8,** wobei
jedes Speichersystem der Speichersysteme jeder der *K* × *L* Zellen (155, 155a) aus *N* in Reihe geschalteten Speicherelementen (1551) besteht, die jeweils ein entsprechendes Bit eines der *N* Bits der N-Bit-Gewichte speichern, die in jeder der Zellen gespeichert ist, wobei ein letztes Speicherelement der Speicherelemente (1551) jedes der Speichersysteme so konfiguriert ist, dass es ein entsprechendes Signal der angelegten Signale empfängt, wobei das entsprechende Signal eine Folge von *M* Bits codiert, und
jede der Recheneinheiten (1552, 1552a) vorzugsweise *N* Ladungsadditionseinheiten umfasst, die über jeweilige Schaltlogiken mit jeweiligen der *N* in Reihe geschalteten Speicherelementen verbunden sind.

10. Eine Hardware-Verarbeitungsvorrichtung (10, 10a), umfassend
eine Speichervorrichtung (10, 10a) mit einer Kreuzgitterstruktur (15), die *K* × *L* Zellen (155, 155a) umfasst, die *K* Zeilen (151, 151a) und *L* Spalten miteinander verbinden, wobei die Zellen jeweilige Speichersysteme umfassen, die jeweilige Gewichte von *N* Bits speichern,
*K* × *L* Recheneinheiten (1552, 1552a), die mit jeweiligen Speichersystemen unter den *K* × *L* Zellen verbunden sind, wobei die Recheneinheiten als verschachtelte analoge Kondensator-Multiplizierer und -Addierer konfiguriert sind; und
eine elektronische Schaltung, die so konfiguriert ist, dass sie synchron Eingangssignale, die jeweilige M-Bit-Eingangswörter an jeweilige Reihen unter den *K* Reihen codieren, anlegt, die Recheneinheiten (1552, 1552a) gemäß einem dreiphasigen Taktschema betreibt und Multiplikations-Akkumulationsergebnisse für jede der *L* Spalten erhält, wobei *K* ≥ 2, *L* ≥ *2, N* ≥ 2 und *M* ≥ 2,
wobei die elektronische Schaltung weiter konfiguriert ist zum
Festlegen des Taktschemas zur Durchführung von *n* × *m* Teilmultiplikationen im analogen Bereich gemäß einer Bitaufteilung, bei der jedes der N-Bit-Gewichte in *n* Bitgruppen und jedes der M-Bit-Eingangswörter in *m* Bitgruppen zerlegt wird, wobei jede der *n* Gruppen und jede der *m* Gruppen mindestens ein Bit umfasst, aber mindestens eine der *n* Gruppen und/oder der *m* Gruppen mindestens zwei Bits umfasst, sodass *N* + *M > n* + *m* ≥ 3 gilt, um *n* × *m* Teilausgangssignale zu erhalten, und
Erhalten der Multiplikations-Akkumulationsergebnisse durch Addieren der von den Recheneinheiten (1552, 1552a) für jede der *L* Spalten erhaltenen Teilausgangssignale, Konvertieren der addierten Ausgangssignale in digitale Signale, die Teilwerte codieren, Verschieben der Teilwerte entsprechend den entsprechenden Bitpositionen, die gemäß der Bitpartitionierung definiert sind, verschoben werden und Addieren der verschobenen Werte, und
wobei die Vorrichtung vorzugsweise außerdem umfasst
eine speichernahe digitale Verarbeitungseinheit (17, 17a), die vorzugsweise in die Kreuzgitterstruktur (15, 15a) integriert ist, wobei die speichernahe digitale Verarbeitungseinheit (17, 17a) mit dem Ausgang der Ausleseschaltung (16) verbunden und so konfiguriert ist, dass sie Operationen auf der Grundlage der in der Ausleseschaltung (16) erhaltenen Multiplikations-Akkumulationsergebnisse durchführt.

11. Die Vorrichtung (10) nach Anspruch **10,** wobei
die Recheneinheiten (1552, 1552a) zusammen mit den Speichersystemen, mit denen sie verbunden sind, an einem Ort angeordnet sind und Teil der jeweiligen Zellen (155) sind, so dass die *n* × *m* Teilmultiplikationen im Betrieb im Speicher durchgeführt werden.

12. Die Vorrichtung (10, 10a) nach Anspruch **10,** wobei
die Vorrichtung (10, 10a) weiter eine speichernahe Verarbeitungseinheit (19) umfasst, wobei letztere die Recheneinheiten umfasst, und
die speichernahe Verarbeitungseinheit (19) vorzugsweise mit der Kreuzgitterstruktur (15, 15a) in der Speichervorrichtung (10, 10a) kointegriert ist.

13. Die Vorrichtung (10, 10a) nach Anspruch **10, 11,** oder **12,** wobei
die elektronische Schaltung eine Ausleseschaltung (16, 16a) umfasst, die folgendes umfasst:
Analog-Digital-Wandler (161), die im Betrieb mit den Ausgängen der jeweiligen Spalten der Recheneinheiten (1552, 1552a) verbunden sind, um die *n* × *m* Teilausgangssignale in digitale Signale umzuwandeln, die die Teilwerte codieren; und
digitale Verschiebe- und Additionsschaltungen, die im Betrieb mit dem Ausgang der jeweiligen Analog-Digital-Wandler (161) verbunden sind, um die Teilwerte entsprechend den entsprechenden Bitpositionen, die gemäß der Bitpartitionierung definiert sind, zu verschieben und die verschobenen Werte zu addieren,
wobei die Ausleseschaltung (16, 16a) vorzugsweise gemeinsam mit der Kreuzgitterstruktur (15, 15a) in der Speichervorrichtung (10, 10a) integriert ist, und
jedes der Speichersysteme der Zellen (155, 155a) vorzugsweise in Reihe geschaltete Speicherelemente (1551) umfasst, die dazu ausgelegt sind, jeweilige Bits einer jeweiligen Gewichtung unter den N-Bit-Gewichtungen zu speichern, wobei die Speicherelemente (1551) im Betrieb vorzugsweise statische RAM-Elemente sind.

14. Die Vorrichtung (10, 10a) nach Anspruch **13,** wobei die elektronische Schaltung weiter umfasst:
eine Eingabeeinheit (11), die zum Anlegen der Eingabesignale konfiguriert ist; und
Steuerkomponenten, die so konfiguriert sind, dass sie
die Recheneinheiten (1552, 1552a) durch Anlegen erster Steuersignale, die dreiphasige Signale umfassen, um das dreiphasige Taktschema zu implementieren, betreiben, und
die Ausleseschaltung (16, 16a) zum Erhalten der Multiplikations-Akkumulationsergebnisse durch Anlegen von zweiten Steuersignalen, die mit den dreiphasigen Signalen phasengleich sind, zu betreiben, wobei im Betrieb die zweiten Steuersignale umfassen
erste Aktivierungssignale zum Aktivieren der Analog-Digital-Wandler (161), um die Teilausgangssignale zu wandeln, und
zweite Aktivierungssignale zum Aktivieren der digitalen Verschiebe- und Additionsschaltung (162) zum Verschieben der Teilwerte und zum Addieren der verschobenen Werte.

15. Ein Computersystem (1) umfassend:
ein oder mehrere Hardware-Verarbeitungsgeräte, jeweils nach einem der Ansprüche **10** bis **14** ;
eine Speichereinheit (2); und
eine mit der Speichereinheit verbundene Allzweck-Verarbeitungseinheit (2) zum Auslesen von Daten aus der Speichereinheit und zum Schreiben von Daten in diese,
wobei
jedes der Hardware-Verarbeitungsgeräte (10, 10a) so konfiguriert ist, dass es Daten aus der Speichereinheit ausliest und Daten in diese schreibt, und
die Allzweck-Verarbeitungseinheit konfiguriert ist, um
eine bestimmte Rechenaufgabe Vektoren und Gewichten zuzuordnen,
die Anweisung zum Speichern (S30) der Gewichte als N-Bit-Gewichte in den Zellen (155, 155a) einer beliebigen der Hardware-Verarbeitungsvorrichtungen zu geben, und
die Anweisung zum Anlegen (S50) von Eingangssignalen, die Vektorkomponenten dieser Vektoren in Form von M-Bit-Eingangswörtern codieren, an Reihen einer beliebigen der Hardware-Verarbeitungsvorrichtungen, um eine solche Rechenaufgabe im Betrieb auszuführen.

## Revendications

1. Procédé de traitement de données, le procédé comprenant :
fournir (S10) un dispositif de mémoire (10, 10a) ayant une structure de réseau crossbar (15) comprenant *K* × *L* cellules (155, 155a) interconnectant *K* rangées (151, 151a) et *L* colonnes, les cellules comprenant des systèmes de mémoire respectifs stockant des poids respectifs de *N* bits, dans lequel les systèmes de mémoire sont connectés à des unités de calcul respectives (1552, 1552a), qui sont configurées comme des multiplicateurs et des additionneurs analogiques à condensateurs commutés entrelacés ; et
appliquer de manière synchrone (S50) des signaux d'entrée codant des mots d'entrée à *M* bits respectifs à des rangées respectives parmi les *K* rangées, faire fonctionner (S60) les unités de calcul selon un schéma d'horloge à trois phases, et obtenir (S70 - S74) des résultats de multiplication-accumulation pour chacune des *L* colonnes, où *K* ≥ 2, *L* ≥ 2, *N* ≥ 2 et *M* ≥ 2, dans lequel
le schéma d'horloge à trois phases est réglé pour effectuer *n* × *m* multiplications partielles, dans le domaine analogique, selon une partition de bits décomposant chacun des poids à *N* bits en *n* groupes de bits et chacun des mots d'entrée à *M* bits en *m* groupes de bits, dans lequel chacun des *n* groupes et des *m* groupes comprend au moins un bit, mais au moins l'un des *n* groupes et/ou des *m* groupes comprend au moins deux bits, de sorte que *N* + *M* > *n + m* ≥ 3, afin d'obtenir *n* × *m* signaux de sortie partiels, et
les résultats de la multiplication-accumulation sont obtenus (S70 - S74) en additionnant les signaux de sortie partiels obtenus par les unités de calcul (1552, 1552a) pour chacune des *L* colonnes, en convertissant (S72) les signaux de sortie additionnés en signaux numériques codant des valeurs partielles, en décalant (S74) les valeurs partielles selon des positions de bits correspondantes définies conformément à la partition de bits, et en additionnant (S74) les valeurs décalées.

2. Procédé selon la revendication **1,** dans lequel
une granularité de la partition de bits des poids à *N* bits et des mots d'entrée à *M* bits est asymétrique, de sorte qu'un nombre moyen de bits des *n* groupes diffère d'un nombre moyen de bits des *m* groupes.

3. Procédé selon la revendication **2,** dans lequel
chacun des *n* groupes a un même nombre v de bits et chacun des *m* groupes a un même nombre *µ* de bits, où v diffère de *µ.*

4. Procédé selon la revendication **3,** dans lequel la partition de bits est conçue de manière à décomposer soit
chacun des poids de *N* bits en *n* groupes de v bits, de telle sorte que *N* = *n* × *v*, où *v* ≥ 2, et chacun des mots d'entrée de *M* bits en un seul groupe de *M* bits, de telle sorte que *m* = 1, ou
chacun des mots d'entrée de *M* bits en *m* groupes de *µ* bits, de telle sorte que *M* = *m* × *µ*, où *µ* ≥ 2, et chacun des poids de *N* bits en un seul groupe de *N* bits, où *n =* 1.

5. Procédé selon la revendication **1,** dans lequel
les unités de calcul (1552, 1552a) sont colocalisées avec les systèmes de mémoire respectifs auxquels elles sont connectées et font partie des cellules respectives (155), de sorte que les *n* × *m* multiplications partielles sont effectuées en mémoire dans le dispositif de mémoire (10).

6. Procédé selon l'une quelconque des revendications **1** à **5,** dans lequel
les résultats de multiplication-accumulation sont obtenus (S70 - S74) via un circuit de lecture (16, 16a), qui comprend :
des convertisseurs analogique-numérique (161) connectés à des colonnes respectives des unités de calcul (1552, 1552a) pour convertir les signaux de sortie partiels tels qu'additionnés pour chacune des *L* colonnes en lesdits signaux numériques ; et
des circuits numériques de décalage et d'addition (162) connectés en sortie de convertisseurs analogiques-numériques respectifs (161) des convertisseurs analogiques-numériques pour décaler les valeurs partielles et additionner les valeurs décalées, et
le circuit de lecture (16) est de préférence cointégré avec la structure de réseau crossbar (15) dans le dispositif de mémoire (10, 10a).

7. Procédé selon la revendication **6,** dans lequel
les unités de calcul (1552, 1552a) fonctionnent (S60) grâce à des premiers signaux de commande, qui comprennent des signaux à trois phases pour mettre en œuvre le schéma d'horloge à trois phases, et
les résultats de multiplication-accumulation sont obtenus (S70 - S74) en appliquant (S70) des seconds signaux de commande, qui sont en phase avec les signaux à trois phases, de manière à permettre un fonctionnement synchrone des unités de calcul (1552, 1552a) et des circuits de lecture (16, 16a), les seconds signaux de commande comprenant :
des premiers signaux d'activation pour activer (S72) les convertisseurs analogique-numérique (161) afin de convertir les signaux de sortie partiels, et
des seconds signaux d'activation pour activer (S74) les circuits numériques de décalage et d'addition (162) afin de décaler les valeurs partielles et d'additionner les valeurs décalées.

8. Procédé selon l'une revendication **1,** dans lequel
le schéma d'horloge à trois phases couvre une séquence de cycles d'horloge, dans lequel la séquence se décompose en *M* ensembles de cycles d'horloge associés à *M* bits respectifs des mots d'entrée à *M* bits,
les signaux à trois phases sont appliqués de manière répétée, *M* fois, pendant les *M* ensembles de cycles d'horloge, et
chacun des *M* ensembles comprend trois cycles d'horloge, pendant lesquels les signaux à trois phases sont appliqués successivement, de telle sorte qu'un seul signal de phase parmi les signaux à trois phases est appliqué pendant un seul des trois cycles d'horloge.

9. Procédé selon la revendication **8,** dans lequel
chaque système de mémoire des systèmes de mémoire de chaque cellule des *K* × *L* cellules (155, 155a) est constitué de *N* éléments de mémoire connectés en série (1551), chacun stockant un bit respectif de l'un des *N* bits des poids à *N* bits qui sont stockés dans ladite chaque cellule, dans laquelle un dernier élément de mémoire des éléments de mémoire (1551) de chacun desdits systèmes de mémoire est configuré pour recevoir un signal respectif des signaux appliqués, le signal respectif codant une séquence de *M* bits, et
chacune des unités de calcul (1552, 1552a) comprend de préférence *N* unités d'addition de charge, qui sont connectées à des éléments respectifs parmi les *N* éléments de mémoire connectés en série via des logiques de commutation respectives.

10. Appareil de traitement matériel (10, 10a), comprenant
un dispositif de mémoire (10, 10a) ayant une structure de réseau crossbar (15) comprenant *K* × *L* cellules (155, 155a) interconnectant *K* rangées (151, 151a) et *L* colonnes, les cellules comprenant des systèmes de mémoire respectifs stockant des poids respectifs de *N* bits,
*K* × *L* unités de calcul (1552, 1552a) connectées à des systèmes de mémoire respectifs parmi les *K* × *L* cellules, dans lequel les unités de calcul sont configurées comme des multiplicateurs et des additionneurs analogiques à condensateurs commutés entrelacés ; et
un circuit électronique configuré pour appliquer de manière synchrone des signaux d'entrée codant des mots d'entrée à *M* bits respectifs à des rangées respectives parmi les *K* rangées, faire fonctionner les unités de calcul (1552, 1552a) selon un schéma d'horloge à trois phases, et obtenir des résultats de multiplication-accumulation pour chacune des *L* colonnes, où *K* ≥ 2, *L* ≥ 2, *N* ≥ 2 et *M* ≥ 2,
dans lequel le circuit électronique est en outre configuré pour
régler le schéma d'horloge pour effectuer *n* × *m* multiplications partielles, dans le domaine analogique, selon une partition de bits décomposant chacun des poids à *N* bits en *n* groupes de bits et chacun des mots d'entrée à *M* bits en *m* groupes de bits, dans lequel chacun des *n* groupes et des *m* groupes comprend au moins un bit, mais au moins l'un des *n* groupes et/ou des *m* groupes comprend au moins deux bits, de sorte que *N + M> n + m* ≥ 3, afin d'obtenir *n* × *m* signaux de sortie partiels, et
obtenir les résultats de multiplication-accumulation en additionnant les signaux de sortie partiels obtenus par les unités de calcul (1552, 1552a) pour chacune des *L* colonnes, en convertissant les signaux de sortie additionnés en signaux numériques codant des valeurs partielles, en décalant les valeurs partielles selon les positions de bits correspondantes définies conformément à la partition de bits, et en additionnant les valeurs décalées, et
dans lequel, de préférence, l'appareil comprend en outre
une unité de traitement numérique proche de la mémoire (17, 17a), qui est de préférence cointégrée à la structure de réseau crossbar (15, 15a), dans laquelle l'unité de traitement numérique proche de la mémoire (17, 17a) est connectée en sortie du circuit de lecture (16) et configurée pour effectuer des opérations sur la base des résultats de multiplication-accumulation obtenus au niveau du circuit de lecture (16).

11. L'appareil (10) selon la revendication **10,** dans lequel
les unités de calcul (1552, 1552a) sont colocalisées avec les systèmes de mémoire auxquels elles sont connectées et font partie des cellules respectives (155), de sorte que les *n* × *m* multiplications partielles sont effectuées en mémoire, en fonctionnement.

12. L'appareil (10, 10a) selon la revendication **10,** dans lequel
l'appareil (10, 10a) comprend en outre une unité de traitement proche de la mémoire (19), cette dernière comprenant les unités de calcul, et
l'unité de traitement proche de la mémoire (19) est de préférence cointégrée avec la structure de réseau crossbar (15, 15a) dans le dispositif de mémoire (10, 10a).

13. L'appareil (10, 10a) selon la revendication **10, 11** ou **12,** dans lequel
le circuit électronique comprend un circuit de lecture (16, 16a), qui comprend
des convertisseurs analogique-numérique (161) connectés en sortie des colonnes respectives des unités de calcul (1552, 1552a), pour convertir les *n* × *m* signaux de sortie partiels en signaux numériques qui codent lesdites valeurs partielles, en fonctionnement ; et
des circuits numériques de décalage et d'addition connectés en sortie des convertisseurs analogique-numérique respectifs (161) pour décaler les valeurs partielles en fonction des positions de bits correspondantes définies conformément à la partition de bits, et ajouter les valeurs décalées, en fonctionnement,
le circuit de lecture (16, 16a) est de préférence cointégré avec la structure de réseau crossbar (15, 15a) dans le dispositif de mémoire (10, 10a), et
chacun des systèmes de mémoire des cellules (155, 155a) comprend de préférence des éléments de mémoire connectés en série (1551), ces derniers étant conçus pour stocker des bits respectifs d'un poids respectif parmi les poids à *N* bits, en fonctionnement, les éléments de mémoire (1551) étant de préférence des éléments de mémoire vive statique.

14. L'appareil (10, 10a) selon la revendication **13,** dans lequel le circuit électronique comprend en outre :
une unité d'entrée (11) configurée pour appliquer lesdits signaux d'entrée ; et
des composants de commande configurés pour faire fonctionner
les unités de calcul (1552, 1552a) en appliquant des premiers signaux de commande qui comprennent des signaux à trois phases pour mettre en œuvre le schéma d'horloge à trois phases, et
le circuit de lecture (16, 16a) pour obtenir les résultats de multiplication-accumulation en appliquant des seconds signaux de commande en phase avec les signaux à trois phases, dans lequel, en fonctionnement, les seconds signaux de commande comprennent
des premiers signaux d'activation pour activer les convertisseurs analogique-numérique (161) afin de convertir les signaux de sortie partiels, et
des seconds signaux d'activation pour activer le circuit numérique de décalage et d'addition (162) afin de décaler les valeurs partielles et d'additionner les valeurs décalées.

15. Système informatique (1) comprenant : un
un ou plusieurs appareils de traitement matériel, chacun selon l'une quelconque des revendications **10** à **14** ;
une unité de mémoire (2) ; et
une unité de traitement à usage général (2) connectée à l'unité de mémoire pour lire des données à partir de l'unité de mémoire et écrire des données dans celle-ci,
dans lequel
chacun des appareils de traitement matériel (10, 10a) est configuré pour lire des données à partir de l'unité de mémoire et pour écrire des données dans celle-ci, et
l'unité de traitement à usage général est configurée pour
mettre en correspondance une tâche de calcul donnée avec des vecteurs et des poids,
donner l'instruction de stocker (S30) lesdits poids sous forme de poids à Nbits dans les cellules (155, 155a) de l'un quelconque des appareils de traitement matériel, et
ordonner l'application (S50) de signaux d'entrée codant des composantes vectorielles de ces vecteurs sous forme de mots d'entrée à M bits à des rangées de n'importe lequel des appareils de traitement matériel, de manière à exécuter une telle tâche de calcul, en fonctionnement.
